(19) Europäisches Patentamt / European Patent Office / Office européen des brevets

(11) **EP 4 782 851 A1**

(12) **DEMANDE DE BREVET EUROPEEN**

(43) Date de publication:
**29.07.2026 Bulletin 2026/31**

(21) Numéro de dépôt: **25305090.0**

(22) Date de dépôt: **24.01.2025**

(51) Classification Internationale des Brevets (IPC):
***G01R 31/12*** *(2020.01)*

(52) Classification Coopérative des Brevets (CPC):
**G01R 31/1272;** G01R 31/1227

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(71) Demandeur: **SCHNEIDER ELECTRIC INDUSTRIES SAS**
**92500 Rueil-Malmaison (FR)**

(72) Inventeurs:
• **ALBERTO, Diego**
**38430 SAINT JEAN DE MOIRANS (FR)**
• **EL KHOURY, Diana**
**38000 GRENOBLE (FR)**
• **DURAND, Maxime**
**38000 GRENOBLE (FR)**

(74) Mandataire: **Plasseraud IP**
**104 Rue de Richelieu**
**CS92104**
**75080 Paris Cedex 02 (FR)**

(54) **PROCÉDÉ DE DÉTECTION DE DÉCHARGES PARTIELLES DANS UN ISOLANT D'UN CONDUCTEUR ÉLECTRIQUE**

(57) Il est proposé un procédé de détection de décharges partielles dans un isolant (2) d'un conducteur électrique (1) de moyenne tension, comportant :
(i) acquérir un ensemble (E) d'échantillons d'un signal électrique (S) représentatif d'une décharge partielle,
(ii) pour chaque échantillon, déterminer la phase (P) de la tension alternative,
(iii) établir une matrice (M) du nombre d'échantillons pour un ensemble de plages d'amplitudes du signal (S) et un ensemble de plages de valeurs de phase (P),
(iv) déterminer dans la matrice (M) établie une zone bruitée (B), en fonction d'une condition basée sur :

- une grandeur statistique représentative d'un nombre de valeurs associées à une plage d'amplitude du signal (S),
- une grandeur statistique représentative d'une variabilité du signal (S),

(v) remplacer chaque élément de la zone bruitée (B) par une combinaison mathématique d'éléments situés hors de la zone bruitée (B) pour former une matrice corrigée (M-c),
(vi) détecter la présence de décharges partielles à partir de la matrice corrigée (M-c).

FIG. 3

EP 4 782 851 A1

## Description

### Domaine technique

La présente divulgation se rapporte au domaine des appareils électriques de moyenne tension ou haute tension, c'est-à-dire une plage de tension allant de 1 kV à plus de 52 kV.

### Technique antérieure

Les appareils électriques opérant sous moyenne tension ou haute tension peuvent subir des décharges partielles entre les conducteurs électriques et l'environnement avoisinant. On entend par décharge partielle une décharge électrique localisée dans une isolation électrique. La décharge est dite partielle car elle ne court-circuite pas l'ensemble de l'isolation. Ces décharges partielles peuvent se propager dans l'air, à l'interface entre l'air et l'isolant, ou à l'intérieur même de la matière isolante. Ces décharges partielles affectent peu à court terme le fonctionnement de l'appareil électrique concerné, mais accélèrent le vieillissement des isolants. Lorsque les isolants sont trop endommagés, un arc électrique franc peut survenir, ce qui peut conduire à la destruction de l'appareil électrique, à une mise hors tension prolongée de parties du réseau électrique, et présenter des risques majeurs pour les personnes situées à proximité de l'appareil. Ainsi, les décharges partielles doivent être détectées afin de permettre une intervention avant un endommagement permanent, une destruction de l'appareil électrique concerné, une coupure d'alimentation prolongée et avant un incident de personne.

Une décharge partielle peut être détectée à partir du signal fourni par un capteur permettant de détecter les variations de champ électrique dans l'isolant entourant un conducteur électrique de l'appareil. Le capteur peut par exemple être un coupleur capacitif, ou un capteur inductif. Un tel capteur fournit généralement un signal de faible amplitude, et le rapport signal/bruit est généralement défavorable à une détection précise des décharges partielles.

Certains réseaux, par exemple intégrant des sources électriques à courant continu, de type sources éoliennes ou sources solaires, peuvent générer un bruit électrique significatif à cause des composants électroniques de conversion de puissance rattachés à ces sources électriques. La détection des décharges partielles est ainsi rendue plus difficile, et aussi bien le taux de non-détection que le taux de fausse détection risque d'être dégradé.

Il existe donc un besoin de disposer d'une méthode de détection de décharges partielles qui soit plus robuste à la présence de bruits électriques dans l'environnement de l'appareil surveillé.

## Résumé

A cette fin, l'invention propose un procédé de détection de décharges partielles dans un isolant d'un conducteur électrique d'un appareil électrique de moyenne tension ou de haute tension, le conducteur électrique étant soumis à une tension alternative, le procédé comportant les étapes :

(i) acquérir successivement un ensemble d'échantillons d'un signal électrique représentatif d'une décharge partielle dans l'isolant du conducteur électrique,

(ii) pour chaque échantillon de l'ensemble d'échantillons, déterminer la valeur de la phase de la tension alternative,

(iii) établir une matrice bidimensionnelle d'éléments, dans laquelle :

- une première dimension de la matrice bidimensionnelle correspond à un ensemble de plages de valeurs de phase de la tension alternative,
- une deuxième dimension de la matrice bidimensionnelle correspond à un ensemble de plages d'amplitudes des échantillons de l'ensemble d'échantillons du signal électrique, et
- la valeur de chaque élément de la matrice bidimensionnelle est égale au nombre d'échantillons compris dans la plage de valeurs de phase de la tension alternative associée audit élément de la matrice bidimensionnelle et compris dans la plage d'amplitude du signal électrique associée audit élément de la matrice bidimensionnelle,

(iv) déterminer dans la matrice bidimensionnelle établie une portion correspondant à un bruit électrique, dite zone bruitée, en fonction d'une condition basée sur au moins :

-- une première grandeur statistique représentative d'un nombre de valeurs associées à une plage d'amplitude du signal électrique,
-- une deuxième grandeur statistique représentative d'une variabilité du nombre de valeurs associées à ladite plage d'amplitude du signal électrique,

(v) pour chaque élément de la matrice bidimensionnelle faisant partie de ladite zone bruitée, remplacer la valeur dudit élément par le résultat d'une fonction mathématique d'au moins :

- un premier élément de la matrice bidimensionnelle situé hors de la zone bruitée, dit premier élément de référence, le premier élément de référence étant associé à :

-- la même plage de valeurs de phase de la tension électrique que ledit élément, et associé à

-- une plage d'amplitude inférieure à la plage d'amplitude dudit élément, et

- un deuxième élément de la matrice bidimensionnelle situé hors de la zone bruitée, dit deuxième élément de référence, le deuxième élément de référence étant associé à :

-- la même plage de valeurs de phase de la tension électrique que ledit élément, et associé à

-- une plage d'amplitude supérieure à la plage d'amplitude dudit élément,

de façon à établir une matrice corrigée bidimensionnelle d'éléments,

(vi) détecter la présence de décharges partielles ou l'absence de décharges partielles dans l'isolant à partir de la matrice corrigée établie.

En identifiant dans la matrice une zone bruitée, et en remplaçant la valeur de chaque élément de la zone bruitée identifiée par un calcul mathématique réalisé sur des éléments encadrants ledit élément de la zone bruitée, le bruit peut être réduit, voire éliminé de la matrice. L'algorithme de détection des décharges partielles peut poursuivre le traitement avec des données dont le bruit a été au moins réduit.

Le nombre et la disposition relative des éléments pris en compte pour le calcul de la valeur de remplacement de chaque élément faisant partie de la zone bruitée peuvent varier.

La présence initiale de bruit superposé au signal réel provenant des décharges partielles est à l'origine d'un risque de non-détection des décharges partielles, ainsi que d'un risque de fausses détections.

Le procédé proposé comprend des étapes de traitement du signal permettant de réduire voire d'éliminer l'effet du bruit. La précision de l'étape de détection des décharges partielles est ainsi améliorée. Aussi bien le taux de non-détection que le taux de fausse détection peuvent être améliorés.

En faisant appel à des combinaisons mathématiques simples, comme des calculs de moyenne, les ressources de calcul nécessaires restent limitées. Le procédé de détection peut être facilement implémenté dans des équipements aux ressources matérielles limitées.

Les caractéristiques listées dans les paragraphes suivant peuvent être mises en œuvre indépendamment les unes des autres ou selon toutes les combinaisons techniquement possibles :

Le signal électrique est une tension de sortie d'un coupleur capacitif.

Le signal électrique est une tension de sortie d'un coupleur inductif.

La fréquence d'échantillonnage du signal électrique est comprise entre 20 MHz et 100 MHz.

La matrice bidimensionnelle est un tableau rectangulaire à deux dimensions.

L'ensemble d'échantillons du signal électrique est acquis pendant une durée prédéterminée.

La valeur de chaque élément de la matrice bidimensionnelle peut être un nombre d'échantillons acquis pendant une durée d'acquisition prédéterminée.

La valeur de chaque élément de la matrice bidimensionnelle peut être un nombre d'échantillons acquis par unité de temps.

L'ensemble de plages de valeurs de la phase de la tension électrique comprend un nombre fixe de plages de valeurs.

Les n plages de valeurs de la phase sont contiguës.

Les n plages de valeurs de la phase ont la même largeur.

L'ensemble de plages d'amplitudes des échantillons du signal électrique comprend un nombre fixe de plages.

Les plages d'amplitudes des échantillons sont contiguës.

Les plages d'amplitudes des échantillons ont la même largeur.

La portion de la matrice correspondant à un bruit, dite zone bruitée, comprend un sous-ensemble des éléments de la matrice bidimensionnelle.

Selon un mode de réalisation du procédé de détection de décharges partielles, pour chaque élément de la matrice bidimensionnelle faisant partie de ladite zone bruitée :

- le premier élément de référence est associé à la plage d'amplitude immédiatement inférieure à la plage d'amplitude dudit élément, et
- le deuxième élément de référence est associé à la plage d'amplitude immédiatement supérieure à la plage d'amplitude dudit élément.

Un élément de la matrice faisant partie de la zone bruitée est remplacé par une valeur directement corrélée aux valeurs des éléments les plus proches ne faisant pas partie de la zone bruitée.

Selon un mode de réalisation du procédé de détection de décharges partielles, pour chaque élément de la matrice bidimensionnelle faisant partie de ladite zone bruitée, la valeur dudit élément est remplacée par le résultat d'une fonction mathématique d'au moins :

- un groupe de premiers éléments de la matrice bidimensionnelle situés hors de la zone bruitée, dit groupe de premiers éléments de référence, chaque élément du groupe de premiers éléments de référence étant respectivement associé à une plage d'amplitude inférieure à la plage d'amplitude dudit élément, et

- un groupe de deuxièmes éléments de la matrice bidimensionnelle situés hors de la zone bruitée, dit groupe de deuxième éléments de référence, chaque élément du groupe de deuxièmes éléments de référence étant respectivement associé à une plage d'amplitude supérieure à la plage d'amplitude dudit élément.

Selon un mode de réalisation, les plages d'amplitudes du groupe de premiers éléments de référence sont des plages consécutives, et les plages d'amplitudes du groupe de deuxièmes éléments de référence sont des plages consécutives.

Selon un mode de réalisation du procédé proposé, pour chaque élément de la matrice bidimensionnelle faisant partie de ladite zone bruitée :

- chaque élément du groupe de premiers éléments de référence est respectivement associé à la même plage de valeurs de phase de la tension électrique que ledit élément, et :
- chaque élément du groupe de deuxièmes éléments de référence est respectivement associé à la même plage de valeurs de phase de la tension électrique que ledit élément.

Selon un autre mode de réalisation du procédé de détection de décharges partielles, pour chaque élément de la matrice bidimensionnelle faisant partie de ladite zone bruitée :

- au moins un élément du groupe de premiers éléments de référence est associé à une plage de valeurs de phase différente de la plage de valeurs de phase dudit élément, et :
- au moins un élément du groupe de deuxièmes éléments de référence est associé à une plage de valeurs de phase différente de la plage de valeurs de phase dudit élément.

Selon un mode de réalisation du procédé de détection de décharges partielles, la première grandeur statistique représentative d'un nombre de valeurs associées à une plage d'amplitude du signal électrique est une valeur moyenne des échantillons du signal électrique, la valeur moyenne étant déterminée sur un sous-ensemble des plages de valeurs de phase de la tension électrique.

Selon un autre mode de réalisation du procédé de détection de décharges partielles, la première grandeur statistique représentative d'un nombre de valeurs associées à une plage d'amplitude du signal électrique est une valeur moyenne des valeurs des éléments de la matrice bidimensionnelle associés à ladite plage d'amplitude du signal électrique, la moyenne étant déterminée sur l'ensemble des plages de valeurs de phase de la tension alternative.

La valeur moyenne est une moyenne arithmétique pondérée.

La valeur moyenne est la moyenne arithmétique.

Selon un autre mode de réalisation, la valeur moyenne est la moyenne géométrique.

Selon un mode de réalisation du procédé de détection de décharges partielles, la deuxième grandeur statistique représentative d'une variabilité du nombre de valeurs associées à ladite plage d'amplitude du signal électrique est un écart-type des valeurs des éléments de la matrice bidimensionnelle associés à ladite plage d'amplitude du signal électrique, l'écart-type étant déterminé sur un sous-ensemble des plages de valeurs de phase de la tension alternative.

Selon un autre mode de réalisation du procédé de détection de décharges partielles, la deuxième grandeur statistique représentative d'une variabilité du nombre de valeurs associées à ladite plage d'amplitude du signal électrique est un écart-type des valeurs des éléments de la matrice bidimensionnelle associés à ladite plage d'amplitude du signal électrique, l'écart-type étant déterminé sur l'ensemble des plages de valeurs de phase de la tension alternative.

Selon un autre mode de réalisation du procédé de détection de décharges partielles, la deuxième grandeur statistique représentative d'une variabilité du nombre de valeurs associées à ladite plage d'amplitude du signal électrique est une variance des échantillons du signal électrique, la variance étant déterminé sur un sous-ensemble des plages de valeurs de phase du courant.

Selon un autre mode de réalisation du procédé de détection de décharges partielles, la deuxième grandeur statistique représentative d'une variabilité du nombre de valeurs associées à ladite plage d'amplitude du signal électrique est une variance des échantillons du signal électrique, la variance étant déterminé sur l'ensemble des plages de valeurs de phase du courant.

Selon une variante, la deuxième grandeur statistique représentative d'une variabilité du nombre de valeurs associées à ladite plage d'amplitude du signal électrique est une différence entre une valeur maximale déterminée sur un sous-ensemble des plages de valeurs de phase de la tension électrique et une valeur minimale déterminée sur ledit sous-ensemble des plages de valeurs de phase de la tension électrique.

Selon une variante, la deuxième grandeur statistique représentative d'une variabilité du nombre de valeurs associées à ladite plage d'amplitude du signal électrique est une différence entre une valeur maximale déterminée sur l'ensemble des plages de valeurs de phase de la tension électrique et une valeur minimale déterminée sur l'ensemble des plages de valeurs de phase de la tension électrique.

La différence déterminée peut être une différence absolue.

La différence déterminée peut être une différence relative.

Selon un mode de réalisation du procédé de détection de décharges partielles, à l'étape (iv), un élément de la matrice bidimensionnelle fait partie de ladite zone bruitée si :

- la première grandeur statistique, déterminée pour la plage d'amplitude dudit élément, est supérieure à un premier seuil, et
- la deuxième grandeur statistique, déterminée pour la plage d'amplitude dudit élément, est inférieure à un deuxième seuil.

Le bruit à traiter présente comme caractéristiques d'être d'un niveau relativement élevé, ce niveau étant de plus relativement constant en fonction de la phase de la tension. L'amplitude varie relativement peu d'une plage de valeurs de phase à une autre plage de valeurs de phase. La première condition d'avoir la première grandeur statistique supérieure à un seuil traduit que le niveau du bruit est relativement élevé. La deuxième condition d'avoir la deuxième grandeur statistique inférieure à un seuil traduit que la variabilité en fonction de la phase de ce niveau de bruit est faible. Les deux conditions doivent être simultanément remplies.

Selon un mode de réalisation du procédé de détection de décharges partielles, à l'étape (iv), un élément de la matrice bidimensionnelle fait partie de ladite zone bruitée si un ratio de :

- la première grandeur statistique, déterminée pour la plage d'amplitude dudit élément, et de
- la deuxième grandeur statistique, déterminée pour la plage d'amplitude dudit élément, est supérieur à un troisième seuil prédéterminé.

Plutôt qu'avoir deux conditions différentes, chacune basée sur une des grandeurs statistiques, une condition basée sur un ratio de ces deux grandeurs statistiques peut être utilisée. Un seul seuil doit être défini, ce que permet de plus facilement calibrer le procédé.

Selon une variante de réalisation du procédé de détection de décharges partielles, à l'étape (iv), un élément de la matrice bidimensionnelle fait partie de ladite zone bruitée si un ratio de :

- la première grandeur statistique, déterminée pour la plage d'amplitude dudit élément, et de
- la valeur maximale entre :

-- la deuxième grandeur statistique, déterminée pour la plage d'amplitude dudit élément, et

-- une constante prédéterminée,

est supérieure à un troisième seuil prédéterminé.

En prenant le maximum entre la deuxième grandeur statistique et une valeur constante, les cas risquant de conduire à une indétermination du calcul sont éliminés. On entend par indétermination les ratios, ou fraction, dans lesquels à la fois le numérateur et le dénominateur de la fraction formée sont proches de zéro.

La constante prédéterminée vaut par exemple un centième du nombre de plages d'amplitudes de la matrice bidimensionnelle, arrondi à l'entier supérieur.

La constante prédéterminée vaut par exemple 1.

Selon un mode de réalisation du procédé de détection de décharges partielles, à l'étape (iv), la zone bruitée de la matrice bidimensionnelle comprend l'ensemble des plages de valeurs de phase du courant.

Selon un mode de réalisation du procédé de détection de décharges partielles, à l'étape (v), la valeur de chaque élément de la matrice bidimensionnelle faisant partie de la zone bruitée est remplacée par une moyenne pondérée de la valeur de l'élément associé à :

- la même plage de valeurs de la phase de la tension alternative, et à
- la plage d'amplitude immédiatement inférieure à la plage d'amplitude dudit élément,

et de la valeur de l'élément associé à :

- la même plage de valeurs de la phase de la tension alternative, et à
- la plage d'amplitude immédiatement supérieure à la plage d'amplitude dudit élément.

Les coefficients de pondération peuvent être identiques. Autrement dit, la moyenne pondérée peut être la moyenne arithmétique.

Les coefficients de pondération peuvent être différents. Autrement dit, une plus grande importance peut être donnée à l'un des deux éléments encadrant l'élément dont on corrige la valeur afin de réduire le bruit.

La moyenne peut être la moyenne géométrique.

Selon un mode de réalisation particulier du procédé de détection de décharges partielles, à l'étape (v), la valeur de chaque élément de la matrice bidimensionnelle faisant partie de la zone bruitée est remplacée par une moyenne arithmétique de :

- la valeur de l'élément associé à la même plage de valeurs de phase de la tension alternative, et à la plage d'amplitude immédiatement inférieure à la plage d'amplitude dudit élément, et de
- la valeur de l'élément associé à la même plage de valeurs de phase de la tension alternative, et à la plage d'amplitude immédiatement supérieure à la plage d'amplitude dudit élément.

Selon un mode de réalisation du procédé de détection de décharges partielles, l'échelle des unités du signal électrique représentatif d'une décharge partielle dans l'isolant du conducteur électrique est une échelle logarithmique.

L'invention concerne aussi un procédé de détection de décharges partielles dans un appareil électrique de moyenne tension ou de haute tension,

l'appareil électrique comprenant :

- un premier conducteur électrique comportant un isolant,
- un deuxième conducteur électrique comportant un isolant,
- un troisième conducteur électrique comportant un isolant,

le premier conducteur électrique, le deuxième conducteur électrique et le troisième conducteur électrique correspondant respectivement à une première phase, une deuxième phase et une troisième phase d'un réseau électrique,

dans lequel un procédé tel que décrit précédemment est mis en oeuvre pour l'isolant de chaque conducteur électrique.

L'invention se rapporte également à un équipement de détection de décharges partielles, comportant :

- un capteur configuré pour fournir un signal électrique représentatif d'une décharge partielle dans un isolant d'un conducteur électrique,
- une unité électronique de contrôle configurée pour mettre en oeuvre le procédé de détection de décharges partielles tel que décrit précédemment.

Selon un mode de réalisation, l'équipement de détection de décharges partielles comporte :

- trois capteurs, chaque capteur étant configuré pour fournir un signal électrique représentatif d'une décharge partielle dans un isolant d'un conducteur électrique,
- une unité électronique de contrôle configurée pour mettre en oeuvre le procédé de détection de décharges partielles tel que décrit précédemment.

L'invention concerne aussi un appareil électrique de moyenne tension ou de haute tension, l'appareil électrique comportant :

- un conducteur électrique,
- un isolant entourant le conducteur électrique,
- un capteur configuré pour fournir un signal électrique représentatif d'une décharge partielle dans l'isolant du conducteur électrique,
- une unité électronique de contrôle configurée pour mettre en œuvre le procédé de détection de décharges partielles décrit précédemment.

Selon un mode de réalisation, l'appareil électrique de moyenne tension ou de haute tension comporte :

- trois conducteurs électriques correspondant respectivement à trois phases d'un réseau électrique triphasé de moyenne tension ou de haute tension,
- trois isolants, chaque isolant entourant respectivement un conducteur électrique,
- trois capteurs, chaque capteur étant respectivement configuré pour fournir un signal électrique représentatif d'une décharge partielle dans l'isolant d'un conducteur électrique,
- une unité électronique de contrôle configurée pour mettre en œuvre, pour chaque isolant, le procédé de détection de décharges partielles tel que décrit précédemment.

**Brève description des dessins**

D'autres caractéristiques, détails et avantages apparaîtront à la lecture de la description détaillée ci-après, et à l'analyse des dessins annexés, sur lesquels :

[Fig. 1] est une représentation schématique d'un appareil électrique de moyenne ou haute tension, sur lequel le procédé proposé peut être mis en œuvre.

[Fig. 2] est un diagramme illustrant certaines étapes du procédé proposé,

[Fig. 3] est un autre diagramme illustrant d'autres étapes du procédé proposé,

[Fig. 4] est un autre exemple du diagramme de la figure 3,

[Fig. 5] est un autre diagramme illustrant d'autres étapes du procédé

[Fig. 6] est un autre exemple du diagramme de la figure 5,

[Fig. 7] est un autre diagramme illustrant d'autres étapes du procédé proposé,

[Fig. 8] est un autre exemple du diagramme de la figure 7,

[Fig. 9] est encore un autre exemple du diagramme de la figure 7,

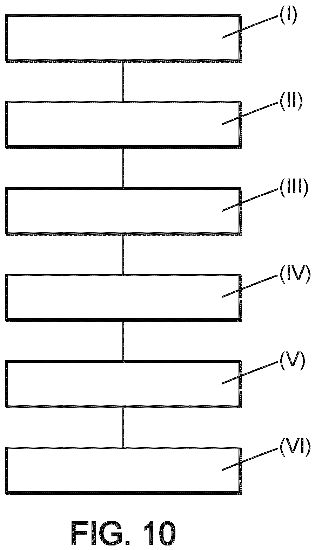

[Fig. 10] est un schéma bloc du procédé proposé.

**Description des modes de réalisation**

Afin de faciliter la lecture des figures, les différents éléments ne sont pas nécessairement représentés à l'échelle. Sur ces figures, les éléments identiques portent les mêmes références. Certains éléments ou paramètres peuvent être indexés, c'est-à-dire désignés par exemple par premier élément ou deuxième élément, ou encore premier paramètre et second paramètre, etc. Cette indexation a pour but de différencier des éléments ou paramètres similaires, mais non identiques. Cette indexation n'implique pas une priorité d'un élément, ou paramètre par rapport à un autre et on peut interchanger les dénominations. Quand il est précisé qu'un dispositif comporte un élément donné, cela n'exclut pas la présence d'autres éléments dans ce dispositif.

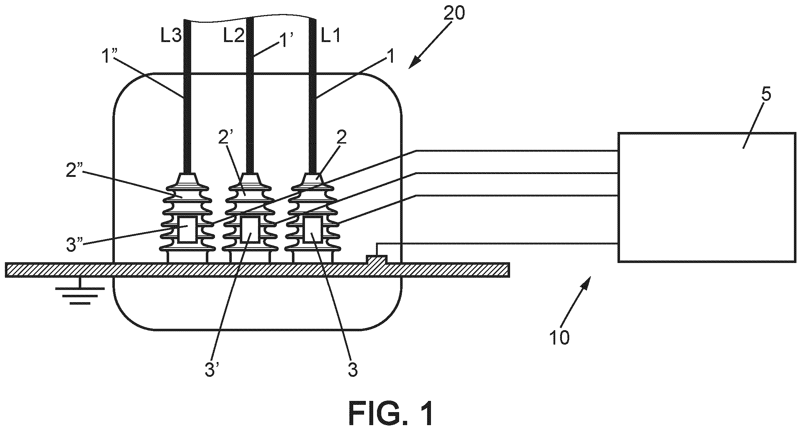

On a représenté schématiquement sur la figure 1 un appareil électrique 20 de moyenne tension ou de haute tension.

L'appareil électrique 20 comporte :

- un conducteur électrique 1,
- un isolant 2 entourant le conducteur électrique 1,
- un capteur 3 configuré pour fournir un signal électrique S représentatif d'une décharge partielle dans l'isolant 2 du conducteur électrique 1.

L'appareil électrique 20 comporte également une unité électronique de contrôle 5 configurée pour mettre en oeuvre un procédé de détection de décharges partielles selon l'invention, qui va être décrit en détail ci-dessous.

Plus précisément, l'appareil électrique 20 de moyenne tension ou de haute tension comporte :

- trois conducteurs électriques 1,1',1" correspondant respectivement à trois phases L1, L2, L3 d'un réseau électrique triphasé de moyenne tension ou de haute tension,
- trois isolants 2,2',2", chaque isolant 2,2',2" entourant respectivement un conducteur électrique 1,1',1",
- trois capteurs 3,3',3", chaque capteur 3,3',3" étant respectivement configuré pour fournir un signal électrique S,S',S" représentatif d'une décharge partielle dans l'isolant 2,2',2" d'un conducteur électrique 1,1',1".

L'unité électronique de contrôle 5 de l'appareil électrique 20 est configurée pour mettre en oeuvre, pour chaque isolant 2,2',2", le procédé de détection de décharges partielles selon l'invention.

Autrement dit, chacun des trois conducteurs électriques 1,1',1"est respectivement entouré d'un isolant 2,2',2". L'appareil électrique 20 comprend trois capteurs de décharge partielle 3,3',3", c'est-à-dire un capteur de décharge partielle pour chacune des trois phases L1, L2, L3.

Chaque capteur de décharge partielle est par exemple un capteur capacitif.

Chaque capteur de décharge partielle peut aussi être du type inductif.

La phase de la tension varie, par convention, entre 0° et 360° (degrés d'angle) pour chacun des conducteurs électriques. La phase exprime les variations périodiques de la tension, la période de variation étant ramenée à une plage angulaire de 0° à 360°. Les termes « phase de la tension » et « angle de phase de la tension » sont équivalents.

La tension est déphasée de 120° entre deux conducteurs électriques.

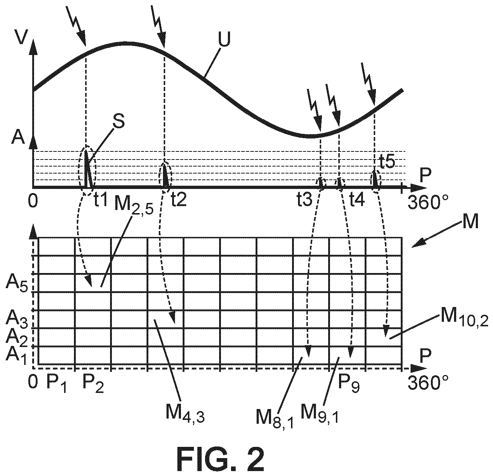

La partie supérieure de la figure 2 illustre schématiquement le phénomène de décharges partielles dans l'isolant 2 d'un conducteur électrique 1.

La courbe désignée par le signe U schématise les variations de la tension électrique à laquelle le conducteur électrique est soumis, en fonction de la phase P de la tension.

Cette phase P varie entre 0° et 360°.

L'invention propose un procédé de détection de décharges partielles dans un isolant 2 d'un conducteur électrique 1 d'un appareil électrique 20 de moyenne tension ou de haute tension, le conducteur électrique 1 étant soumis à une tension alternative U.

Le procédé proposé comporte l'étape :

(i) acquérir successivement un ensemble E d'échantillons d'un signal électrique S représentatif d'une décharge partielle dans l'isolant 2 du conducteur électrique 1.

Le procédé proposé comporte l'étape :
(ii) pour chaque échantillon de l'ensemble E d'échantillons, déterminer la valeur de la phase P de la tension alternative.

Le procédé proposé comporte l'étape :
(iii) établir une matrice bidimensionnelle M d'éléments $M_{i,j}$, dans laquelle :

- une première dimension de la matrice bidimensionnelle M correspond à un ensemble de plages de valeurs de phase P de la tension alternative,
- une deuxième dimension de la matrice bidimensionnelle M correspond à un ensemble de plages d'amplitudes des échantillons de l'ensemble E d'échantillons du signal électrique S, et
- la valeur de chaque élément $M_{i,j}$ de la matrice bidimensionnelle M est égale au nombre d'échantillons compris dans la plage de valeurs de phase P de la tension alternative associée audit élément de la matrice bidimensionnelle M et compris dans la plage d'amplitude du signal électrique S associée audit élément de la matrice bidimensionnelle M.

Le procédé proposé comporte l'étape :

(iv) déterminer dans la matrice bidimensionnelle M établie une portion B correspondant à un bruit électrique, dite zone bruitée B, en fonction d'une condition basée sur au moins :

-- une première grandeur statistique G1 représentative d'un nombre de valeurs associées à une plage d'amplitude du signal électrique S,
-- une deuxième grandeur statistique G2 représentative d'une variabilité du nombre de valeurs associées à ladite plage d'amplitude du signal électrique S.

Le procédé proposé comporte l'étape :
(v) pour chaque élément $M_{i,j}$ de la matrice bidimensionnelle M faisant partie de ladite zone bruitée B, remplacer la valeur dudit élément $M_{i,j}$ par le résultat d'une fonction mathématique d'au moins :

- un premier élément de la matrice bidimensionnelle M situé hors de la zone bruitée B, dit premier élément de référence R1, le premier élément de référence R1 étant associé à :

-- la même plage de valeurs de phase P de la tension électrique que ledit élément $M_{i,j}$, et associé à
-- une plage d'amplitude inférieure à la plage d'amplitude dudit élément $M_{i,j}$, et

- un deuxième élément de la matrice bidimensionnelle M situé hors de la zone bruitée B, dit deuxième élément de référence R2, le deuxième élément de référence R2 étant associé à :

-- la même plage de valeurs de phase P de la tension électrique que ledit élément $M_{i,j}$, et associé à
-- une plage d'amplitude supérieure à la plage d'amplitude dudit élément $M_{i,j}$,

de façon à établir une matrice corrigée bidimensionnelle M_Cor d'éléments.

Le procédé proposé comporte l'étape :
(vi) détecter la présence de décharges partielles ou l'absence de décharges partielles dans l'isolant 2 à partir de la matrice corrigée M_Cor établie.
Les premières étapes du procédé visent à établir une matrice M du nombre N d'échantillons acquis, en fonction de leur amplitude A et de leur phase P. Une partie, ou certaines parties de cette matrice M peuvent correspondre à du bruit électrique, et non à un signal exploitable. Un tel bruit électrique risque de générer des fausses détections et/ou des non-détections de décharges partielles.
Le procédé proposé permet d'identifier dans la matrice bidimensionnelle M établie au moins une zone bruitée B.

Les valeurs de la zone bruitée B identifiée sont remplacées à partir d'un calcul mathématique réalisé sur des éléments de la matrice encadrant cette zone bruitée B, mais situés en dehors de cette zone bruitée B. Le bruit peut ainsi être réduit, voire éliminé de la matrice M. L'algorithme de détection des décharges partielles peut poursuivre le traitement avec une matrice corrigée de données présentant un niveau de bruit réduit.
En faisant appel à des combinaisons mathématiques simples, comme des calculs de moyenne, les ressources de calcul nécessaires restent limitées. Le procédé de détection peut ainsi être facilement implémenté dans des équipements aux ressources matérielles limitées.
La valeur de remplacement des éléments $M_{i,j}$ de la matrice bidimensionnelle M faisant partie de la zone bruitée B est déterminée à partir de la valeur d'au moins deux éléments voisins situés hors de ladite zone bruitée, et il est possible de prendre en compte plus que deux éléments voisins, comme on le décrira par la suite.
Selon l'exemple illustré, le signal électrique S est une tension de sortie d'un coupleur capacitif.
Le signal électrique S est obtenu par couplage capacitif entre le capteur de mesure 3 et l'isolant 2 du conducteur électrique 1.
Selon une variante de réalisation non illustrée, le signal électrique S est une tension de sortie d'un coupleur inductif.
Le signal électrique S est obtenu par couplage inductif entre le capteur de mesure 3 et l'isolant 2 du conducteur électrique 1.
Le signal électrique S est échantillonné. La fréquence d'échantillonnage du signal électrique est comprise entre 20 MHz et 100 MHz.
La figure 2 illustre l'acquisition du signal S et la formation de la matrice bidimensionnelle M.
La partie supérieure de la figure 2 illustre la tension U à laquelle le conducteur électrique 1 et l'isolant 2 sont soumis, ainsi que le signal S délivré par le capteur de décharge partielle. L'axe des abscisses correspond à la phase P, et l'axe des ordonnées correspond à la tension U ainsi qu'au signal S. Les courbes représentatives du signal S et de la tension U ne sont pas à l'échelle.
La courbe représentée correspond à une unique période du signal.
A l'instant correspondant à la phase indiquée par le signe t1, une première décharge partielle se produit dans l'isolant. L'amplitude A du signal associé correspond à 5 carreaux, l'échelle choisie étant purement illustrative.
A l'instant correspondant à la phase indiquée par le signe t2, une deuxième décharge partielle se produit, avec une plus faible amplitude, correspondant à une amplitude de 3 carreaux.
Deux autres décharges partielles, d'amplitude 1, se produisent respectivement aux phases indiquées par les signes t3 et t4. Sur l'exemple de la figure 2, une dernière décharge partielle se produit pour la phase t5, d'amplitude 2 carreaux.

Chaque décharge partielle est comptabilisée dans une matrice bidimensionnelle M. La matrice bidimensionnelle M est un tableau rectangulaire à deux dimensions.

Le tableau comprend un ensemble de rangées horizontales, et un ensemble de colonnes verticales.

Un élément $M_{i,j}$ est disposé à l'intersection de la colonne de rang i et de la ligne de rang j. Chaque élément $M_{i,j}$ de la matrice bidimensionnelle M est associé à :

- une plage de valeurs de phase P de la tension alternative, et
- une plage d'amplitude du signal électrique S.

La valeur d'un élément $M_{i,j}$ de la matrice bidimensionnelle M est le nombre d'échantillons N dont :

- l'amplitude appartient à la plage d'amplitudes $A_j$ correspondante, et
- la phase appartient à la plage de valeurs de phase $P_i$ correspondante.

A titre d'exemple, un échantillon de phase 105° et d'amplitude 5 est comptabilisé par l'élément associé à la plage de phase [100°,120°] et à la plage d'amplitudes [4,8].

Un échantillon de phase 110° et d'amplitude 7 est aussi comptabilisé par le même élément de la matrice.

Un échantillon de phase 165° et d'amplitude 3 est comptabilisé par l'élément associé à la plage de phase [160°,180°] et à la plage d'amplitudes [0,4].

L'ensemble de plages de valeurs de la phase P de la tension électrique comprend ici un nombre fixe de plages de valeurs. Ce nombre est ici désigné par n. Les termes 'plages de valeurs de la phase P' et 'plages de valeurs de phase P' sont équivalents.

Les n plages de valeurs de la phase P sont rangées par ordre croissant.

Les n plages de valeurs de la phase P sont contiguës. Autrement dit, la borne supérieure d'une plage est égale à la borne inférieure de la plage de rang immédiatement supérieur, lorsque cette plage existe. De même, la borne inférieure d'une plage est égale à la borne supérieure de la plage de rang immédiatement inférieur, lorsque cette plage existe.

La borne inférieure de la première plage correspond à la valeur minimale de l'ensemble des valeurs, c'est-à-dire 0°. La borne supérieure de la dernière plage correspond à la valeur maximale de l'ensemble des valeurs, c'est-à-dire 360°.

Les n plages de valeurs de la phase P ont de préférence la même largeur.

Par exemple, l'étendue totale des valeurs de phases est divisée en 24 plages de 15°. La première plage couvre les valeurs de 0° à 15°, la deuxième plage couvre les valeurs de 15° à 30°, la troisième de 30° à 45°, et ainsi de suite.

Selon un autre exemple, l'étendue totale des valeurs de phases est divisée en 120 plages de 3°.

Pour simplifier la figure 2, l'ensemble de plages de valeurs de la phase P comprend 10 plages, correspondant à 10 colonnes de la matrice M.

L'ensemble de plages d'amplitudes des échantillons du signal électrique S comprend un nombre fixe de plages. Ce nombre est désigné par m. Les termes 'plages d'amplitudes' et 'plages de valeurs d'amplitude' sont équivalents.

Les m plages d'amplitudes permettant de répartir les échantillons sont rangées par ordre croissant. Les m plages d'amplitudes des échantillons sont contiguës. Comme précédemment, la borne supérieure d'une plage est égale à la borne inférieure de la plage de rang immédiatement supérieur.

Les m plages d'amplitudes des échantillons ont la même largeur.

Les différentes plages de valeurs de la phase P correspondent, sur l'exemple de la figure 2, aux différentes colonnes de la matrice. Dans une colonne, les plages d'amplitudes sont rangées par ordre croissant, et la plage de phase P ne varie pas. La première plage $P_1$, la deuxième plage $P_2$, la neuvième plage $P_9$ sont indiquées. Les différentes plages d'amplitudes des échantillons correspondent, sur cette figure 2, aux lignes de la matrice M. Dans une ligne, les plages de phase P sont rangées par ordre croissant, et la plage d'amplitude ne varie pas. La première plage $A_1$, la deuxième plage $A_2$, la troisième plage $A_3$ et la cinquième plage $A_5$ sont indiquées.

La matrice bidimensionnelle M comprend donc le produit n * m éléments. Chaque élément $M_{i,j}$ est référencé dans la matrice M par deux indices indépendants i et j, avec i variant de 1 à n et j variant de 1 à m.

Selon un exemple non représenté, il est bien sur possible de transposer la matrice M, c'est-à-dire de permuter le rôle des lignes et des colonnes de la matrice.

Chaque échantillon acquis est associé à une amplitude du signal électrique S et à une phase P de la tension électrique U à l'instant de l'acquisition.

Chaque échantillon comprend un couple de valeurs :

- une valeur est l'amplitude du signal électrique S représentatif d'une décharge partielle, correspondant à un instant d'acquisition donnée, et
- l'autre valeur est la valeur de la phase de la tension électrique U au même instant d'acquisition.

Deux échantillons distincts correspondent à deux instants d'acquisition distincts.

La partie inférieure de la figure 2 illustre comment la matrice M est établie.

La décharge partielle s'étant produite à l'instant t1 tombe dans la deuxième plage de phase $P_2$ et la cinquième plage d'amplitude $A_5$.

La décharge partielle s'étant produite à l'instant t2 tombe dans la quatrième plage de phase $P_4$ et la troisième plage d'amplitude $A_3$.

Les décharges partielles de l'instant t3 et de l'instant t4 tombent toutes les deux dans la première plage d'am-

plitude $A_1$, et respectivement dans la huitième plage de phase $P_8$ et la neuvième plage de phase $P_9$.

Pour chaque décharge partielle, l'élément correspondant de la matrice bidimensionnelle M est incrémenté de 1. L'élément $M_{2,5}$ est ainsi incrémenté de 1 en raison de la décharge partielle de l'instant $t_1$, l'élément $M_{4,3}$ est incrémenté en raison de la décharge partielle de l'instant $t_2$, l'élément $M_{8,1}$ est incrémenté de 1 en raison de la décharge partielle de l'instant $t_3$, l'élément $M_{9,1}$ est incrémenté de 1 en raison de la décharge partielle de l'instant $t_4$ et l'élément $M_{10,2}$ est incrémenté de 1 en raison de la décharge partielle de l'instant $t_5$.

L'ensemble E d'échantillons du signal électrique S est acquis pendant une durée prédéterminée.

Par exemple, le signal électrique S du capteur de décharge partielle 3 est acquis pendant 30 minutes consécutives.

Pour chaque période de la tension électrique, les échantillons de mesure acquis lors de cette période sont ajoutés à la matrice M déjà formée.

Le nombre d'échantillons de mesure compris dans la matrice M augmente donc régulièrement au cours de l'acquisition des données.

La durée d'acquisition est adaptée à la fréquence d'échantillonnage utilisée.

La valeur de chaque élément $M_{i,j}$ de la matrice bidimensionnelle M peut être un nombre d'échantillons acquis pendant une durée d'acquisition prédéterminée.

Par exemple, la valeur de chaque élément $M_{i,j}$ de la matrice bidimensionnelle M peut être le nombre d'échantillons acquis pendant 30 minutes.

La valeur de chaque élément $M_{i,j}$ de la matrice bidimensionnelle M peut aussi être un nombre d'échantillons acquis par unité de temps.

Par exemple, la valeur de chaque élément $M_{i,j}$ de la matrice bidimensionnelle M peut être le nombre d'échantillons par seconde tombant dans le couple de plage d'amplitude et plage de phase correspondant à l'élément $M_{i,j}$.

La procédure d'établissement de la matrice bidimensionnelle M est généralement désignée par l'acronyme Anglais 'PRPD', pour 'Phase Resolved Partial Discharge'.

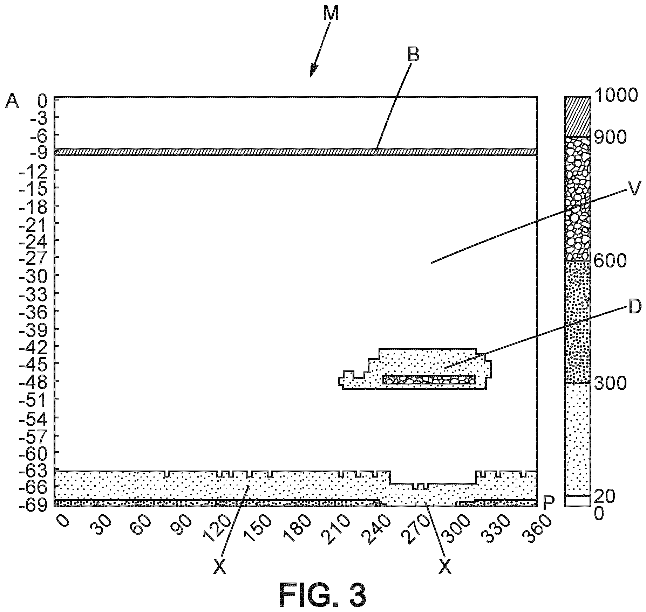

La figure 3 est une représentation graphique d'un exemple de matrice formée, ici après une acquisition d'une durée de 30 minutes.

Sur cette représentation, le nombre N d'échantillons correspondant à un élément donné de la matrice est représenté par le motif employé.

Afin de simplifier la figure, seules cinq plages de valeurs de N ont été représentées.

La première plage, correspondant aux plus faibles amplitudes, est représentée par un fond blanc.

Ainsi, tous les éléments pour lesquels le nombre d'échantillons associé est proche de zéro sont en blanc.

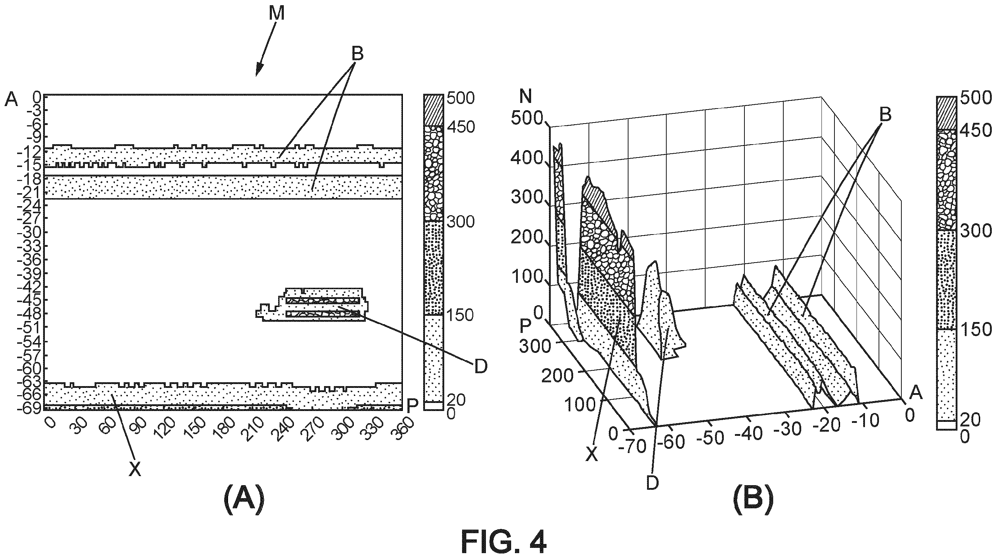

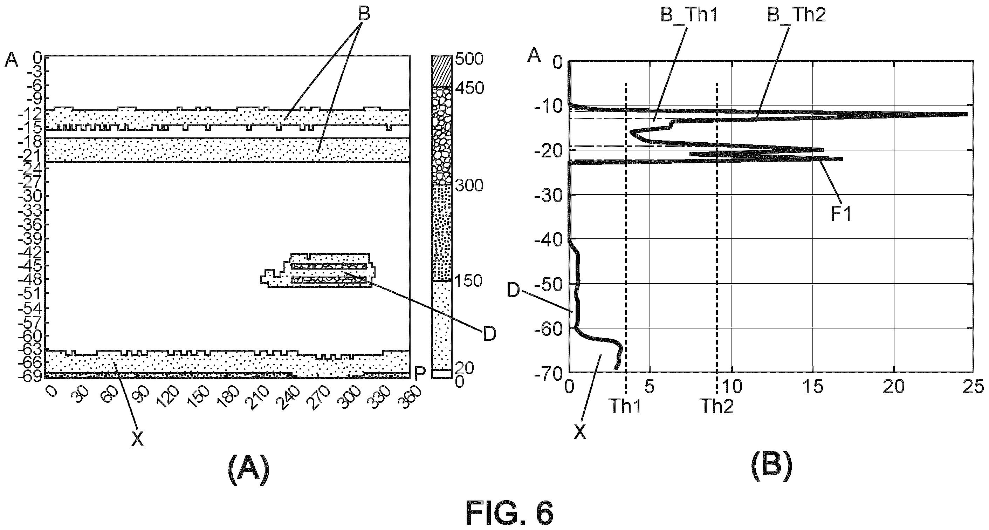

Le même code de représentation est utilisé pour la figure 4 et la figure 6.

Selon l'exemple de la figure 3, l'échelle des unités du signal électrique S représentatif d'une décharge partielle dans l'isolant 2 du conducteur électrique 1 est une échelle logarithmique.

Le signal électrique S correspond ici à 20 fois le logarithme du ratio de la tension de sortie du capteur 3, et d'une tension de référence.

L'unité du signal électrique S est ainsi le décibel. (dB)

L'ensemble de plages d'amplitudes des échantillons du signal électrique S comprend ici 70 plages.

La largeur d'une plage est ici de 1 unité.

L'échelle varie entre - 69 dB, pour les signaux de plus faible amplitude, et 0 dB, pour les signaux de plus forte amplitude.

Sur la figure 3, la plus grande partie de la matrice M, désignée par le signe V, correspond à des éléments comprenant un nombre très faible d'échantillons, ce nombre étant quasiment nul.

La zone désignée par le signe D correspond à la partie réellement représentative des décharges partielles. On constate que les décharges partielles se produisent pour des valeurs de phase variant relativement peu, ces valeurs variant entre environ 220° et 330°. De même, l'amplitude associée est centrée autour de -45 dB.

La zone désignée par le signe X correspond à une amplitude A très faible du signal, et ne correspond pas à une décharge partielle. Cette partie de la matrice M est à conserver.

La partie désignée par B correspond à du bruit. Autrement dit, cette partie des éléments de la matrice M ne correspond pas à des décharges partielles, mais à du bruit électrique lié à l'environnement du capteur de décharges partielles 3. En effet, l'appareil électrique 20, ou d'autres dispositifs électriques situés à proximité de l'appareil électrique 20, peuvent comporter des éléments de commutation qui génèrent un bruit élevé, comme des redresseurs ou des hacheurs.

Ce bruit électrique n'est pas lié à la phase P de la tension alternative U dans le conducteur 1 pour lequel les décharges partielles dans l'isolant 2 sont analysées, et apparait comme un trait continu sur le diagramme représentant les éléments de la matrice M.

Sur l'exemple de la figure 3, la zone dite bruitée B apparait sous la forme d'un trait horizontal fin, car cette zone bruitée B comprend une seule plage d'amplitude.

La partie A de la figure 4 est une représentation graphique d'un autre exemple de matrice formée, correspondant à un autre exemple.

La partie B est une représentation tridimensionnelle de la matrice de la partie A.

Les deux axes A, P dans le plan horizontal correspondent aux plages d'amplitudes A du signal et aux plages de valeur de phase P. L'axe vertical N correspond au nombre d'échantillons pour chaque plage d'amplitude $A_i$ et chaque plage de valeurs de phase $P_j$.

La zone bruitée B s'étend sur une bande de plages d'amplitudes plus large que dans le cas de la figure 3, et couvre en partie plusieurs plages d'amplitudes, s'étendant approximativement de -25dB à -10 dB.

La portion de la matrice M correspondant à un bruit, dite zone bruitée B, comprend ainsi un sous-ensemble des éléments de la matrice bidimensionnelle M.

Une fois la zone bruitée B identifiée, les éléments formant cette zone bruitée B sont remplacés par d'autres valeurs, déduites de la valeur des éléments adjacents à la zone bruitée B mais ne faisant pas partie de cette zone bruitée B.

Selon un mode de réalisation du procédé de détection de décharges partielles, pour chaque élément $M_{i,j}$ de la matrice bidimensionnelle M faisant partie de ladite zone bruitée B :

- le premier élément de référence R1 est associé à la plage d'amplitude immédiatement inférieure à la plage d'amplitude dudit élément $M_{i,j}$, et
- le deuxième élément de référence R2 est associé à la plage d'amplitude immédiatement supérieure à la plage d'amplitude dudit élément $M_{i,j}$.

Pour un élément $M_{i,j}$, associé à la plage d'amplitudes $A_j$, la plage d'amplitude immédiatement inférieure est la plage d'amplitudes $A_{j-1}$. La plage d'amplitude immédiatement supérieure est la plage d'amplitudes $A_{j+1}$.

Un élément de la matrice M faisant partie de la zone bruitée B est ainsi remplacé par une valeur directement corrélée aux valeurs des éléments les plus proches et ne faisant pas partie de la zone bruitée B.

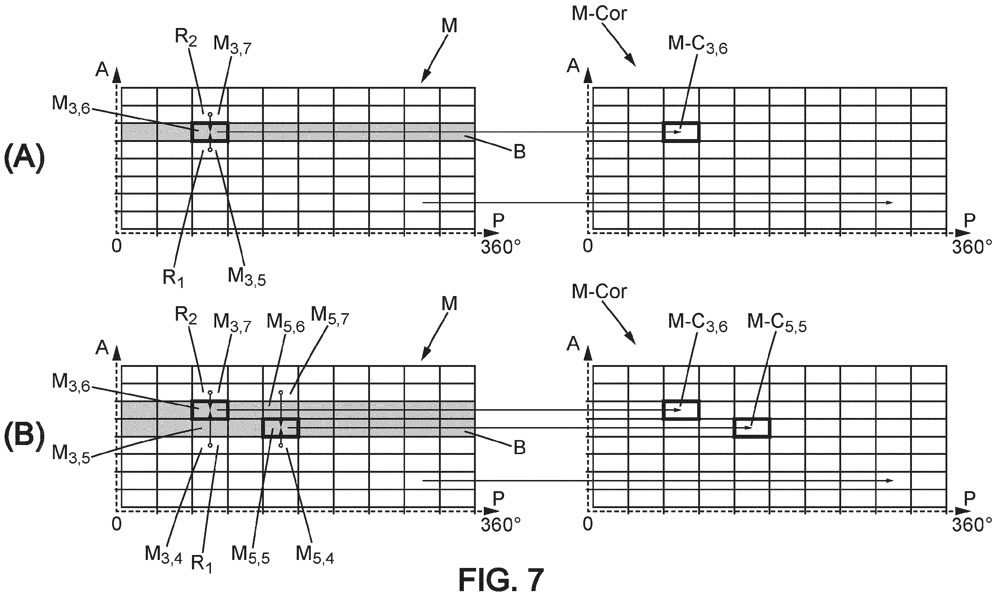

La partie A de la figure 7 illustre l'étape de remplacement d'un élément de la zone bruitée B. Cette zone bruitée B est schématisée en couleur grise.

Sur cette partie A, la zone bruitée B concerne une seule plage d'amplitude du signal, qui est la sixième plage.

En considérant l'élément $M_{3,6}$ de la ligne bruitée B correspondant à la troisième plage de valeurs de phase, le premier élément de référence R1 est l'élément adjacent à la zone bruitée B, n'appartenant pas à la zone bruitée B, et correspondant à la plage d'amplitude inférieure, soit l'élément $M_{3,5}$.

Le deuxième élément de référence R2 est, pour l'élément $M_{3,6}$, l'élément adjacent à la zone bruitée B, n'appartenant pas à la zone bruitée B et correspond à la plage d'amplitude supérieure à celle de l'élément $M_{3,6}$, soit l'élément $M_{3,7}$.

A partir des valeurs de ces deux éléments de référence, une nouvelle valeur est calculée, et est attribuée à l'élément correspondant de la matrice corrigée M-C.

L'élément $M\text{-}C_{3,6}$ de la matrice corrigée M-C est obtenu par une opération mathématique réalisée sur les éléments $M_{3,5}$ et $M_{3,7}$ de la matrice M.

Lorsqu'au moins une partie de la zone bruitée B recouvre une zone correspondant à des décharges partielles réelles, le remplacement des valeurs de la zone bruitée par un calcul mathématique réalisé sur les valeurs des éléments voisins non bruités permet de reconstruire des valeurs exploitables.

Les éléments situés en dehors de la zone bruitée, schématisés par les cases blanches sur les figures 7, 8, 9 ne sont pas modifiés, et leur valeur est affectée sans modification à la matrice corrigée M-C, comme schématisé par le trait horizontal.

Dans le cas où la plage d'amplitude maximale fait partie de la zone bruitée B, il n'y a pas d'élément de plage d'amplitude immédiatement supérieure à la plage d'amplitude des éléments dont on veut remplacer la valeur.

Dans ce cas, on considère que le deuxième élément de référence R2 est identique au premier élément de référence R1. Autrement dit, la valeur de chaque élément de la matrice faisant partie de la zone bruitée B est remplacée par la valeur de l'élément le plus proche associé à la même plage de phase, et ne faisant pas partie de la zone bruitée B.

De la même manière, lorsque la plage d'amplitude minimale fait partie de la zone bruitée B, il n'y a pas d'élément de plage d'amplitude immédiatement inférieure à la plage d'amplitude des éléments dont on veut remplacer la valeur. On considère alors que le premier élément de référence R1 est identique au deuxième élément de référence R2. Autrement dit, la valeur de chaque élément de la matrice faisant partie de la zone bruitée est remplacée par la valeur de l'élément le plus proche associé à la même plage de phase, et ne faisant pas partie de la zone bruitée B.

Diverses grandeurs statistiques peuvent être employées pour déterminer la zone bruitée B de la matrice M.

Selon un mode de réalisation du procédé de détection de décharges partielles, la première grandeur statistique G1 représentative d'un nombre de valeurs associées à une plage d'amplitude du signal électrique S est une valeur moyenne Moy des échantillons du signal électrique,

la valeur moyenne Moy étant déterminée sur un sous-ensemble des plages de valeurs de phase de la tension électrique.

Autrement dit, la valeur moyenne caractérisant une plage d'amplitude peut être déterminée sur une partie seulement de l'intervalle total de variation de la phase, c'est-à-dire 360°.

Selon un autre mode de réalisation du procédé de détection de décharges partielles, la première grandeur statistique G1 représentative d'un nombre de valeurs associées à une plage d'amplitude du signal électrique S est une valeur moyenne Moy des valeurs des éléments $M_{i,j}$ de la matrice bidimensionnelle M associés à ladite plage d'amplitude du signal électrique S,

la moyenne Moy étant déterminée sur l'ensemble des plages de valeurs de phase de la tension alternative.

Dans ce cas, toutes les plages de valeurs de phase sont prises en compte, c'est-à-dire que la moyenne est calculée sur la totalité de l'intervalle 0° à 360°.

Selon un exemple de mise en œuvre du procédé, la valeur moyenne est une moyenne arithmétique pondérée.

Pour un ensemble p éléments $X_1$, $X_2$, ..., $X_p$, la moyenne arithmétique pondérée est donnée par l'expression :

[Math. 1]

$$Mp = \frac{\sum_{i=1}^{p}(K_{i*}X_{i})}{\sum_{i=1}^{p}K_{i}}$$

Avec Mp la moyenne arithmétique pondérée,
et $K_1$, $K_2$, ..., $K_p$ les coefficients de pondération respectivement associés aux éléments $X_1$, $X_2$, ... , $X_p$.

Selon un exemple particulier, la valeur moyenne est la moyenne arithmétique.

Autrement dit, les coefficients de pondération peuvent être identiques. La valeur moyenne est ainsi égale à la somme des valeurs de différents éléments d'une même ligne, cette somme étant divisée par le nombre d'éléments à prendre en compte. Lorsque la moyenne est réalisée sur l'ensemble des plages de valeur de phase, c'est le nombre de colonnes dans la matrice M.

Selon un autre exemple de mise en oeuvre, la valeur moyenne est la moyenne géométrique.

Comme pour la première grandeur statistique, la deuxième grandeur statistique G2 peut être déterminée suivant différentes méthodes.

L'écart-type est un indicateur possible pour quantifier la variabilité des valeurs des différents éléments de la matrice M.

Par définition, l'écart-type est, pour un ensemble de valeurs, la moyenne quadratique des écarts à la moyenne. C'est aussi la racine carrée de la variance.

Ainsi, selon un mode de réalisation du procédé proposé, la deuxième grandeur statistique G2 représentative d'une variabilité du nombre de valeurs associées à ladite plage d'amplitude du signal électrique S est un écart-type des valeurs des éléments $M_{i,j}$ de la matrice bidimensionnelle M associés à ladite plage d'amplitude du signal électrique S,
l'écart-type étant déterminé sur un sous-ensemble des plages de valeurs de phase de la tension alternative.

Selon une variante du procédé proposé, la deuxième grandeur statistique G2 représentative d'une variabilité du nombre de valeurs associées à ladite plage d'amplitude du signal électrique S est un écart-type des valeurs des éléments $M_{i,j}$ de la matrice bidimensionnelle M associés à ladite plage d'amplitude du signal électrique S,
l'écart-type étant déterminé sur l'ensemble des plages de valeurs de phase de la tension alternative.

Autrement dit, la deuxième grandeur statistique G2 peut être déterminée sur une partie seulement de l'intervalle total de variation de la phase, ou sur la totalité de l'intervalle 0° à 360°.

La variance est un autre indicateur possible pour quantifier la variabilité des valeurs des différents éléments de la matrice M.

Par définition, la variance d'un ensemble de valeurs est la moyenne arithmétique des carrés des écarts à la moyenne.

Ainsi, selon un autre mode de réalisation du procédé de détection de décharges partielles, la deuxième grandeur statistique G2 représentative d'une variabilité du nombre de valeurs associées à ladite plage d'amplitude du signal électrique S est une variance des échantillons du signal électrique,
la variance étant déterminé sur un sous-ensemble des plages de valeurs de phase du courant.

Selon un autre mode de réalisation du procédé de détection de décharges partielles, la deuxième grandeur statistique G2 représentative d'une variabilité du nombre de valeurs associées à ladite plage d'amplitude du signal électrique S est une variance des échantillons du signal électrique,
la variance étant déterminé sur l'ensemble des plages de valeurs de phase du courant.

Par définition, l'écart-type est la racine carrée de la variance, les deux indicateurs fournissent donc des résultats similaires.

Selon un autre mode de réalisation, la deuxième grandeur statistique G2 représentative d'une variabilité du nombre de valeurs associées à ladite plage d'amplitude du signal électrique S est une différence entre une valeur maximale Max déterminée sur un sous-ensemble des plages de valeurs de phase de la tension électrique et une valeur minimale Min déterminée sur ledit sous-ensemble des plages de valeurs de phase de la tension électrique.

Selon une variante, la deuxième grandeur statistique G2 représentative d'une variabilité du nombre de valeurs associées à ladite plage d'amplitude du signal électrique S est une différence entre une valeur maximale Max déterminée sur l'ensemble des plages de valeurs de la phase de la tension électrique et une valeur minimale Min déterminée sur l'ensemble des plages de valeurs de la phase de la tension électrique.

La différence déterminée peut une différence absolue. Autrement dit, le calcul est basé sur la différence entre la valeur de l'élément de valeur la plus élevée et la valeur de l'élément de valeur la plus faible.

Le procédé proposé comporte ainsi une sous-étape de détermination de la valeur maximale parmi un ensemble d'éléments.

Le procédé comporte également une sous-étape de détermination de la valeur minimale parmi cet ensemble d'éléments.

La différence déterminée peut une différence relative.

Autrement dit, la différence absolue préalablement calculée est ensuite divisée par la plus grande valeur entre la valeur maximale déterminée et la valeur minimale déterminée. La différence obtenue peut par exemple être exprimée en %.

En variante, la différence absolue préalablement calculée est ensuite divisée par la plus petite valeur entre la valeur maximale déterminée et la valeur minimale déterminée.

Le test d'appartenance à la zone bruitée B peut également être basé sur différentes conditions.

Selon un mode de réalisation du procédé proposé, à l'étape (iv), un élément $M_{i,j}$ de la matrice bidimensionnelle M fait partie de ladite zone bruitée B si :

- la première grandeur statistique G1, déterminée pour la plage d'amplitude dudit élément $M_{i,j}$, est supérieure à un premier seuil, et
- la deuxième grandeur statistique G2, déterminée pour la plage d'amplitude dudit élément $M_{i,j}$, est inférieure à un deuxième seuil.

Le bruit que l'on cherche à éliminer, ou au moins à réduire, présente comme caractéristiques d'être d'un niveau relativement élevé, ce niveau étant de plus relativement constant en fonction de la phase de la tension. L'amplitude du bruit varie ainsi relativement peu en fonction de la phase de la tension.
La première condition d'avoir la première grandeur statistique G1 supérieure à un seuil choisi traduit que le niveau absolu du bruit est relativement élevé.
La deuxième condition d'avoir la deuxième grandeur statistique G2 inférieure à un seuil traduit que la variabilité du bruit en fonction de la phase est faible. Les deux conditions doivent être simultanément remplies pour que les éléments concernés de la matrice M soient identifiés comme du bruit.

Autrement dit, la condition pour qu'un élément $M_{i,j}$ de la matrice bidimensionnelle M fasse partie de ladite zone bruitée B est remplie lorsque les deux conditions sont simultanément satisfaites :

- la première grandeur statistique G1, déterminée pour la plage d'amplitude correspondant à cet élément $M_{i,j}$, est supérieure à un premier seuil, et
- la deuxième grandeur statistique G2, également déterminée pour la plage d'amplitude correspondant à cet élément $M_{i,j}$, est inférieure à un deuxième seuil.

Pour une plage d'amplitude donnée, le test de détermination de la zone bruitée peut être réalisé sur un sous-ensemble de l'ensemble des plages de fréquence, c'est-à-dire que seulement une partie de l'ensemble des plages de fréquence pour le test.
Le résultat du test de détermination concerne l'ensemble des plages de fréquence.
Ainsi, pour une plage d'amplitude donnée, si les plages des fréquence utilisées pour calculer le critère d'appartenance à la zone bruitée indique que ces plages de fréquence font partie de la zone bruitée, les autres plages de fréquence associées à la même plage d'amplitude sont également considérées comme faisant partie de la zone bruitée.
Autrement dit, la zone bruitée B comprend seulement des lignes complètes dans la matrice d'échantillons d'acquisition.

Selon un autre mode de réalisation du procédé de détection de décharges partielles, à l'étape (iv), un élément $M_{i,j}$ de la matrice bidimensionnelle M fait partie de ladite zone bruitée B si un ratio F1 de :

- la première grandeur statistique G1, déterminée pour la plage d'amplitude dudit élément $M_{i,j}$, et de
- la deuxième grandeur statistique G2, déterminée pour la plage d'amplitude dudit élément $M_{i,j}$,

est supérieur à un troisième seuil prédéterminé Th.

Plutôt qu'avoir deux conditions différentes, chacune basée sur une des grandeurs statistiques, une condition basée sur un ratio de ces deux grandeurs statistiques peut être utilisée. Un seul seuil doit être défini, ce que permet de plus facilement calibrer le procédé.

Selon une variante de réalisation du procédé de détection de décharges partielles, à l'étape (iv), un élément $M_{i,j}$ de la matrice bidimensionnelle M fait partie de ladite zone bruitée B si un ratio F1 de :

- la première grandeur statistique G1, déterminée pour la plage d'amplitude dudit élément $M_{i,j}$, et de
- la valeur maximale entre :

-- la deuxième grandeur statistique G2, déterminée pour la plage d'amplitude dudit élément $M_{i,j}$, et
-- une constante prédéterminée c,

est supérieure à un troisième seuil Th prédéterminé.

Le ratio F1 est ainsi donné par l'expression mathématique :

[Math. 2]

$$F1 = \frac{G1}{Max(G2, c)}$$

Le ratio F1 caractérise une plage d'amplitude $A_j$ de la matrice M, chaque plage d'amplitude possède donc sa propre valeur du ratio F1.

En prenant le maximum entre la deuxième grandeur statistique G2 et une valeur constante c, les cas risquant de conduire à une indétermination sont éliminés. On entend par indétermination les ratios, ou fractions, dans lesquels à la fois le numérateur et le dénominateur de la fraction formée sont proches de zéro.

La constante prédéterminée c vaut par exemple un centième du nombre de plages d'amplitudes de la matrice bidimensionnelle M, arrondi à l'entier supérieur. La constante prédéterminée c vaut par exemple 1.

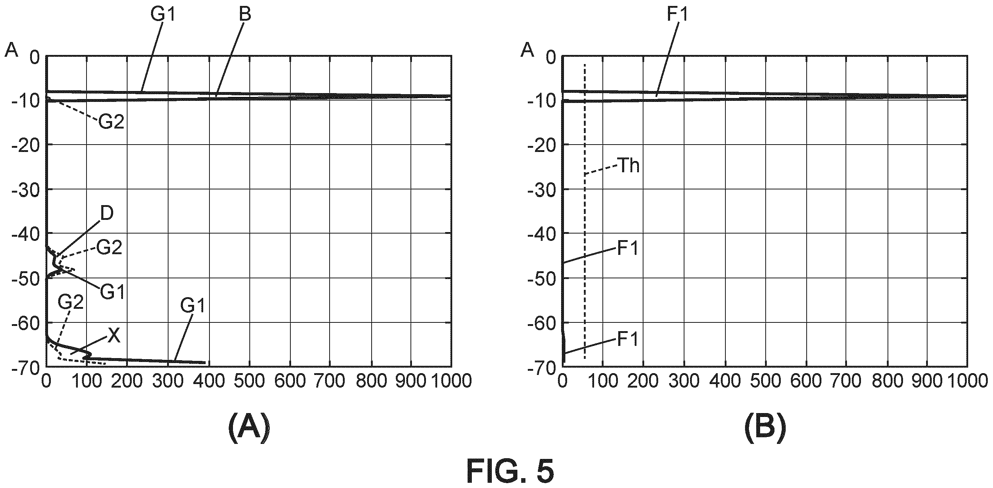

La figure 5 illustre le comportement des grandeurs statistiques G1 et G2, calculées sur la matrice de la figure 3.

La figure 6 illustre le comportement des grandeurs statistiques G1 et G2, calculées sur la matrice de la partie A de la figure 4.

Sur la partie A de la figure 5, la grandeur statistique G1 correspond à la moyenne, déterminée sur l'ensemble des plages de valeurs de phase. La grandeur statistique G2 correspond à l'écart-type, là aussi déterminé sur l'ensemble des plages de valeur de phase. La courbe désignée par F1 correspond au ratio de G1 et de G2, c'est-à-dire la division de G1 par G2, soit la moyenne divisée par l'écart-type.

Dans la zone désignée par le signe D, correspondant à des décharges partielles réelles, l'écart-type G2 et la moyenne G1 sont du même ordre de grandeur, compris autour de 50.

Dans la zone désignée par X, la moyenne est plus élevée que dans la zone D, et là aussi la moyenne G1 et l'écart type G2 sont du même ordre de grandeur. La moyenne G1 est supérieure à l'écart-type G2.

Dans la zone bruitée B, la moyenne G1 est nettement plus élevée, de l'ordre de 1000 échantillons par plage de valeur de phase, et l'écart-type G2 est très faible, de valeur inférieure à 1 et confondue avec l'axe vertical de l'amplitude A.

Dans la zone B, la valeur retenue de G2 pour calculer le ratio de G1 sur G2 est donc bornée par la valeur maximale c, qui vaut ici 1.

La partie B de la figure 5 représente la valeur calculée F1 du ratio de G1 et G2. La valeur retenue pour G2 valant 1, le ratio F1 égal à la moyenne G1.

Dans la zone D et la zone X, la moyenne G1 et l'écart-type G2 sont du même ordre de grandeur, le ratio F1 prend donc une valeur d'au plus quelques unités.

Avec une échelle permettant de bien visualiser le ratio F1 dans la zone bruitée B, le ratio F1 est, pour la zone D, confondu avec l'épaisseur de l'axe vertical A, et est quasiment confondu également dans la zone X.

La ligne verticale pointillée indique la valeur du seuil Th. L'écart du ratio F1 entre la zone bruitée B et les autres zones non bruitées D, X étant très important, la distinction entre les différentes zones est très facile à faire.

Les zones pour lesquelles le ratio F1 est supérieur au seuil choisi Th font partie de la zone bruitée B, et les zones pour lesquelles le ratio F1 est inférieur au seuil choisi Th ne font pas partie de la zone bruitée B. Ces zones sont ainsi hors de la zone bruitée B, et les valeurs des éléments correspondant de la matrice sont conservés sans modification.

Sur la figure 6, la zone bruitée B recouvre plusieurs plages d'amplitudes, comme on peut le voir sur la partie A de la figure.

La valeur moyenne G1 est ainsi plus faible que dans le cas de la figure 5, et l'écart-type G2 est plus élevé.

Le ratio F1, représenté sur la partie B de la figure 6, prend donc des valeurs plus faibles que sur la figure 5.

Comme précédemment, les différentes zones peuvent être facilement distinguées.

Deux choix possibles de seuils sont schématisés sur la partie B de la figure 6.

Avec la valeur Th1, toutes les plages d'amplitudes comprises entre -10 et -22 ont une valeur du ratio G1 sur G2 supérieure à la valeur Th1. La zone bruitée B comprend ainsi des plages d'amplitudes contiguës.

En choisissant pour le seuil limite la valeur Th2, plus élevée que Th1, une partie des plages d'amplitudes comprises entre -10 et -22 ont une valeur du ratio G1 sur G2 inférieure à la valeur choisie du seuil Th2. La condition d'appartenance à la zone bruitée B n'est donc pas respectée, et ces zones sont considérées comme hors de la zone bruitée B. La zone bruitée B comprend ainsi une première bande de plages d'amplitudes contiguës et une deuxième bande de plages d'amplitudes contiguës, ces deux bandes étant séparées par une bande de plages d'amplitudes ne faisant pas partie de la zone bruitée B.

Le signe B_Th1 désigne la zone bruitée dans le cas où la valeur Th1 est utilisée pour le test d'appartenance à la zone bruitée, et le signe B_Th2 désigne la zone bruitée si c'est la valeur Th2 qui est utilisée.

Selon le mode de réalisation illustré du procédé de détection de décharges partielles, à l'étape (iv), la zone bruitée B de la matrice bidimensionnelle M comprend l'ensemble des plages de valeurs de phase du courant.

Autrement dit, le critère statistique permettant d'identifier la zone bruitée B peut exploiter seulement une partie des plages de fréquences, pour une plage d'amplitudes donnée. Si la condition d'appartenance à la zone bruitée B est remplie, l'ensemble des plages de valeurs de phase associée à une plage d'amplitude A fait partie de la zone bruitée B.

En d'autres termes, sur l'exemple illustré, la zone bruitée B comprend des lignes complètes, c'est-à-dire couvrant la plage de phase 0° à 360°.

On détaillera maintenant l'étape (v) du procédé proposé, dans laquelle les valeurs faisant partie de la zone bruitée B préalablement identifiée sont remplacées par d'autres valeurs.

Selon un mode de réalisation du procédé de détection de décharges partielles, à l'étape (v), la valeur de chaque élément $M_{i,j}$ de la matrice bidimensionnelle M faisant partie de la zone bruitée B est remplacée par une moyenne pondérée de la valeur de l'élément $M_{i,j-1}$, associé à :

- la même plage $P_i$ de valeurs de la phase de la tension alternative, et à
- la plage d'amplitude $A_{j-1}$ immédiatement inférieure à la plage d'amplitude $A_j$ dudit élément $M_{i,j}$,

et de la valeur de l'élément $M_{i,j+1}$ associé à :

- la même plage $P_i$ de valeurs de la phase de la tension alternative, et à
- la plage d'amplitude $A_{j+1}$ immédiatement supérieure à la plage d'amplitude $A_j$ dudit élément $M_{i,j}$.

La partie A de la figure 7 schématise cette étape.

La zone bruitée B y est schématisée par la ligne grisée associée à la sixième plage d'amplitude.

On considère l'élément $M_{3,6}$, correspondant à la troisième plage de valeurs de phase.

L'élément $M_{3,7}$ correspondant à la même plage de phase et à la plage d'amplitude immédiatement supérieure à celle de l'élément $M_{3,6}$ est situé hors de la zone bruitée B. De même, l'élément $M_{3,5}$ correspondant à la même plage de phase et à la plage d'amplitude immédiatement inférieure à celle de l'élément $M_{3,6}$ est également situé hors de la zone bruitée B. Ces deux éléments sont donc utilisés pour fournir une valeur de remplacement, dite valeur débruitée, à l'élément $M_{3,7}$. Le résultat de l'opération mathématique entre $M_{3,7}$ et $M_{3,5}$ forme l'élément M-$C_{3,6}$ de la matrice corrigée M-C. Le même traitement est appliqué aux autres éléments de la même ligne, c'est-à-dire de la sixième plage d'amplitude.

Les zones de la matrice bidimensionnelle M ne faisant pas partie de la zone bruitée B, c'est-à-dire les zones pour lesquelles le critère d'appartenance à la zone bruitée n'est pas vérifié, ne subissent aucun traitement. Les valeurs des éléments de ces zones non bruitées sont donc recopiées sans modification sans la matrice corrigée M-C.

Les coefficients de pondération peuvent être différents. Autrement dit, une plus grande importance peut être donnée à l'un des deux éléments encadrant l'élément dont on corrige la valeur afin d'atténuer le bruit.

Les coefficients de pondération peuvent être identiques. Autrement dit, la moyenne pondérée peut être la moyenne arithmétique.

Dans ce cas, la valeur de l'élément $M_{i,j}$ est remplacée par la somme divisée par deux de l'élément $M_{i,j-1}$ et de l'élément $M_{i,j+1}$.

Dans ce cas particulier, à l'étape (v), la valeur de chaque élément $M_{i,j}$ de la matrice bidimensionnelle M faisant partie de la zone bruitée B est remplacée par une moyenne arithmétique de :

- la valeur de l'élément $M_{i,j-1}$ associé à la même plage $P_i$ de valeurs de phase de la tension alternative, et à la plage d'amplitude $A_{j-1}$ immédiatement inférieure à la plage d'amplitude $A_j$ dudit élément $M_{i,j}$ et de
- la valeur de l'élément $M_{i,j+1}$ associé à la même plage $P_i$ de valeurs de phase de la tension alternative, et à la plage d'amplitude $A_{j+1}$ immédiatement supérieure à la plage d'amplitude $A_j$ dudit élément $M_{i,j}$.

Dans ce cas, les deux éléments encadrant l'élément de la zone bruitée ont la même importance dans la détermination de la valeur corrigée. Les calculs à réaliser sont plus simples qu'avec une moyenne pondérée dans laquelle les coefficients diffèrent l'un de l'autre.

La moyenne peut être la moyenne géométrique.

Sur la partie B de la figure 7, la zone bruitée B comprend deux plages d'amplitudes adjacentes, c'est-à-dire consécutives. La zone bruitée B est ainsi schématisée par deux lignes grisées contiguës.

On considère l'élément $M_{3,6}$, correspondant à la troisième plage de valeurs de phase et la plage d'amplitude la plus élevée de la zone bruitée.

L'élément $M_{3,7}$ correspondant à la même plage de phase et à la plage d'amplitude immédiatement supérieure à celle de l'élément $M_{3,6}$, est situé hors de la zone bruitée B. Cet élément est donc utilisable pour la détermination de la valeur corrigée.

L'élément $M_{3,5}$ correspondant à la même plage de phase et à la plage d'amplitude immédiatement inférieure à celle de l'élément $M_{3,6}$ fait lui aussi partie de la zone bruitée B, et n'est donc pas utilisable pour la détermination de la valeur corrigée.

L'élément $M_{3,4}$ correspondant à la même plage de phase et à la plage d'amplitude de deux rangs inférieure à celle de l'élément $M_{3,6}$ est en dehors de la zone bruitée B. Cet élément est l'élément de plage d'amplitude inférieure à celle de l'élément bruité qui est le plus proche utilisable. La valeur de remplacement de l'élément $M_{3,6}$, dite valeur débruitée, est donc calculée à partir de la valeur de l'élément $M_{3,7}$ et de la valeur de l'élément $M_{3,4}$.

Le résultat de l'opération mathématique entre $M_{3,7}$ et $M_{3,4}$ forme ainsi l'élément M-$C_{3,6}$ de la matrice corrigée M-C. Comme précédemment, le même traitement est appliqué aux autres éléments de la même ligne.

On considère maintenant l'élément $M_{5,5}$, faisant partie de la plage d'amplitude la plus faible de la zone bruitée B.

L'élément $M_{5,4}$ correspondant à la même plage de phase et à la plage d'amplitude immédiatement inférieure à celle de l'élément $M_{5,5}$, est situé hors de la zone bruitée B, et est donc utilisable pour la détermination de la valeur corrigée.

L'élément $M_{5,6}$ correspondant à la même plage de phase et à la plage d'amplitude immédiatement supérieure à celle de l'élément $M_{5,5}$ fait lui aussi partie de la zone bruitée B, et n'est donc pas utilisable pour la détermination de la valeur corrigée.

L'élément $M_{5,7}$ correspondant à la même plage de phase et à la plage d'amplitude de deux rangs supérieure à celle de l'élément $M_{5,5}$ est en dehors de la zone bruitée B. Cet élément est l'élément de plage d'amplitude supérieure à celle de l'élément bruité $M_{5,5}$ qui est le plus proche utilisable.

La valeur de remplacement de l'élément $M_{5,5}$, dite valeur débruitée, est donc calculée à partir de la valeur de l'élément $M_{5,7}$ et de la valeur de l'élément $M_{5,4}$.

Le résultat de l'opération mathématique entre $M_{5,7}$ et $M_{5,4}$ forme l'élément M-$C_{5,5}$ de la matrice corrigée M-C. Comme précédemment, le même traitement est appliqué aux autres éléments de la même ligne.

Tous les éléments de la zone bruitée B sont ainsi traités de la même manière. Seuls deux éléments de la matrice corrigée M-C ont été schématisés, afin de simplifier la figure.

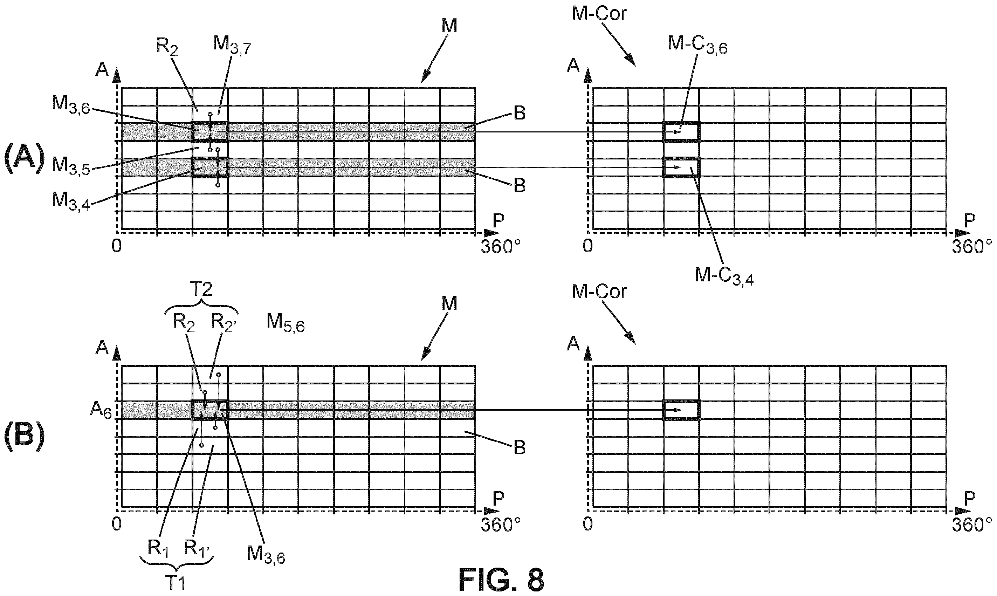

La partie A de la figure 8 schématise un cas dans lequel la zone bruitée B comprend deux plages d'amplitudes non contiguës.

L'élément $M_{3,4}$ et l'élément $M_{3,6}$ font tous les deux partie de la zone bruitée B.

L'élément $M_{3,5}$ séparant ces deux éléments est situé au dehors de cette zone bruitée B, et n'en fait donc pas partie.

L'élément $M_{3,5}$ est utilisé pour la détermination de la valeur de remplacement de l'élément $M_{3,4}$ ainsi que de l'élément $M_{3,6}$. L'élément $M_{3,5}$ est l'élément de la plage d'amplitude supérieure pour $M_{3,4}$ et est l'élément de plage d'amplitude inférieure pour $M_{3,6}$.

Les deux lignes grisées de la matrice M sont traitées de la même manière.

La valeur de remplacement d'un élément de la zone bruitée B peut être déterminée à partir de plus de deux valeurs entourant cet élément de la zone bruitée.

Par exemple, selon un mode de réalisation du procédé proposé, pour <u>chaque</u> élément $M_{i,j}$ de la matrice bidimensionnelle M faisant partie de ladite zone bruitée B, la valeur dudit élément $M_{i,j}$ est remplacée par le résultat d'une fonction mathématique d'au moins :

    - un groupe de premiers éléments de la matrice bidimensionnelle M situés hors de la zone bruitée B, dit groupe T1 de premiers éléments de référence, chaque élément du groupe T1 de premiers éléments de référence étant respectivement associé à une plage d'amplitude inférieure à la plage d'amplitude dudit élément $M_{i,j}$, et

    - un groupe de deuxièmes éléments de la matrice bidimensionnelle M situés hors de la zone bruitée B, dit groupe T2 de deuxième éléments de référence, chaque élément RI du groupe T2 de deuxièmes éléments de référence étant respectivement associé à une plage d'amplitude supérieure à la plage d'amplitude dudit élément $M_{i,j}$.

Selon un mode de réalisation, les plages d'amplitudes du groupe T1 de premiers éléments de référence sont des plages consécutives, et

les plages d'amplitudes du groupe T2 de deuxièmes éléments de référence sont des plages consécutives.

Selon un mode de réalisation, pour chaque élément Mi,j de la matrice bidimensionnelle M faisant partie de ladite zone bruitée B :

    - chaque élément du groupe T1 de premiers éléments de référence est respectivement associé à la même plage de valeurs de phase P de la tension électrique que ledit élément $M_{i,j}$, et :

    - chaque élément du groupe T2 de deuxièmes éléments de référence est respectivement associé à la même plage de valeurs de phase P de la tension électrique que ledit élément $M_{i,j}$.

La partie B de la figure 8 illustre schématiquement ce mode de réalisation, dans le cas où le groupe T1 comprend deux premiers éléments de référence R1 et R1', et où le deuxième groupe T2 comprend lui aussi deux deuxièmes éléments de référence R2 et R2'. Les deux premiers éléments de référence R1 et R1' correspondent aux deux plages d'amplitudes consécutives situés en dehors de la zone bruitée B, et correspondant à des plages d'amplitudes inférieures à celle de la zone bruitée, désigné par $A_6$.

Les deux deuxièmes éléments de référence R2 correspondent aux deux plages d'amplitudes consécutives situés en dehors de la zone bruitée B, et correspondant à des plages d'amplitudes supérieures à la plage d'amplitude $A_6$ de la zone bruitée.

Chaque groupe T1, T2 peut comprendre davantage que deux éléments. Par exemple, chaque groupe T1, T2 peut comprendre trois éléments.

Le groupe T1 de premiers éléments de référence et le groupe T2 de deuxièmes éléments de référence peuvent comprendre des nombres différents d'éléments.

Ces deux cas de figure n'ont pas été schématisés.

Selon un autre mode de réalisation du procédé proposé, pour chaque élément Mi,j de la matrice bidimensionnelle M faisant partie de ladite zone bruitée B :

    - au moins un élément du groupe T1 de premiers éléments de référence est associé à une plage de valeurs de phase P différente de la plage de valeurs de phase dudit élément $M_{i,j}$, et :

    - au moins un élément du groupe T2 de deuxièmes éléments de référence est associé à une plage de valeurs de phase P différente de la plage de valeurs de phase dudit élément $M_{i,j}$.

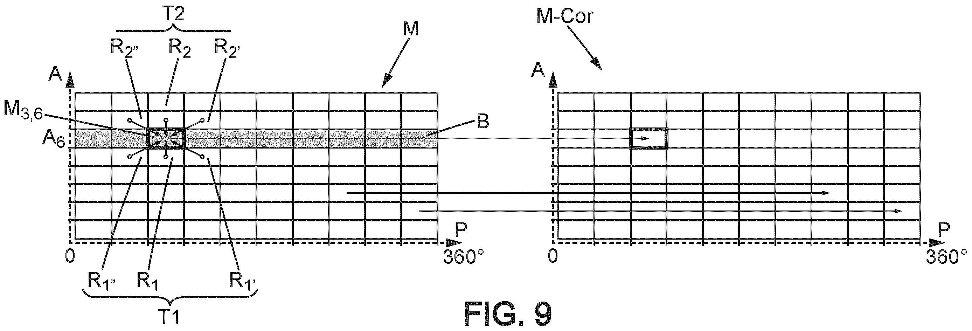

La figure 9 illustre schématiquement un exemple de ce mode de réalisation.

Sur cet exemple, le groupe T1 de premiers éléments de référence comprend, pour chaque élément $M_{i,j}$ de la zone bruitée B : l'élément associé à la plage de valeurs de phase inférieure à celle de l'élément $M_{i,j}$, l'élément associé à la plage de valeurs de phase inférieure à celle de l'élément $M_{i,j}$, et l'élément associé à la même plage de valeurs de phase que celle de l'élément $M_{i,j}$.

En illustrant pour l'élément $M_{3,6}$ : le groupe T1 de premiers éléments de référence comprend l'élément R1" associé à la plage de valeurs de phase inférieure à celle de l'élément $M_{3,6}$, l'élément R1' associé à la plage de valeurs de phase supérieure à celle de l'élément $M_{3,6}$, et l'élément R1 associé à la même plage de valeurs de phase inférieure que celle de l'élément $M_{3,6}$.

De la même manière, pour l'élément $M_{3,6}$, le groupe T2 de deuxièmes éléments de référence comprend l'élément R2" associé à la plage de valeurs de phase inférieure à celle de l'élément $M_{3,6}$, l'élément R2' associé à la plage de valeurs de phase supérieure à celle de l'élément $M_{3,6}$, et l'élément R2 associé à la même plage de valeurs de phase inférieure que celle de l'élément $M_{3,6}$.

Dans cet exemple, les six éléments les plus proches d'un élément $M_{i,j}$ de la zone bruitée B, tout en étant au dehors de la zone bruitée B, sont pris en compte pour le calcul de la valeur de remplacement de cet élément $M_{i,j}$.

Pour l'élément de la première plage de valeurs de phase, il n'y a pas d'élément correspondant à la plage inférieure. Dans ce cas, seul l'élément correspondant à la même plage et l'élément correspondant à la plage supérieure sont pris en compte.

De la même manière, l'élément de la zone bruitée associé à la dernière plage de valeur n'a pas d'élément voisin correspondant à une plage de valeurs plus élevée. Seul l'élément correspondant à la même plage et l'élément correspondant à la plage inférieure sont alors pris en compte.

Sur l'exemple de la figure 9, les éléments du groupe T1 de premiers éléments de référence sont associés à des plages de valeurs de phase consécutives, c'est-à-dire qui se suivent sans être séparées par une autre plage de phase.

Il en est de même pour les éléments du groupe T2 de deuxièmes éléments de référence.

Il est envisageable de choisir les éléments du groupe T1 de premiers éléments de référence tels que deux éléments successifs de ce groupe sont séparés par une plage de phase dont l'élément ne fait lui-même pas partie du groupe T1.

De la même façon, les éléments du groupe T2 de deuxièmes éléments de référence peuvent être choisis tels que deux éléments successifs du groupe T2 sont séparés par une plage de phase dont l'élément ne fait lui-même pas partie du groupe T1.

Ce cas n'a pas été représenté.

D'autres fonctions mathématiques que celles déjà listées peuvent être utilisées pour déterminer la valeur de remplacement de chaque élément de la matrice bidimensionnelle M faisant partie de la zone bruitée B.

Par exemple, un polynôme en plusieurs indéterminées peut être utilisé.

Les indéterminées sont les éléments du groupe T1 de premiers éléments de référence et les éléments du groupe T2 de deuxièmes éléments de référence.

Une interpolation non linéaire parmi les éléments du groupe T1 de premiers éléments de référence et les éléments du groupe T2 de deuxièmes éléments de référence peut également être employée.

Par exemple, une interpolation par des fonctions splines de degré 3 peut être employée.

Les étapes (i) à (v) forme des étapes d'un procédé de réduction de bruit d'un signal électrique représentatif d'une décharge partielle dans l'isolant d'un conducteur électrique de moyenne tension ou de haute tension.

Une fois la matrice corrigée bidimensionnelle M_Cor établie, l'étape (vi) de détection de décharges partielles est réalisée de cette matrice corrigée.

Divers algorithmes de détection basés sur l'exploitation d'une matrice dite 'PRPD', connus de l'homme du métier, peuvent être utilisés.

Par exemple, la méthode listée dans l'article rédigé en Anglais « The effects of superimposed impulse transients on partial discharge in XLPE cable joint », publié dans la revue Electrical Power and Energy Systems 110 (2019) 497 - 509 peut être mise en oeuvre. D'autres exemples sont fournis par le mémoire de thèse de Edward Gulski, également rédigé en Anglais, « Computer aided recognition of partial dicharges using statistical tools ».

Le procédé a été décrit dans le cas où la détection de décharges partielles est réalisée pour un seul des trois conducteurs électriques de l'appareil électrique 20. Le procédé proposé peut être simultanément appliqué à chacun des conducteurs électriques, de façon à protéger au mieux l'appareil électrique 20.

L'invention concerne donc également un procédé de détection de décharges partielles dans un appareil électrique 20 de moyenne tension ou de haute tension, l'appareil électrique 20 comprenant :

- un premier conducteur électrique 1 comportant un isolant 2,
- un deuxième conducteur électrique 1' comportant un isolant 2',
- un troisième conducteur électrique 1" comportant un isolant 2",

le premier conducteur électrique 1, le deuxième conducteur électrique 1' et le troisième conducteur électrique 1" correspondant respectivement à une première phase, une deuxième phase et une troisième phase d'un réseau électrique,

dans lequel un procédé tel que décrit précédemment est mis en œuvre pour l'isolant 2, 2', 2" de chaque conducteur électrique 1,1',1".

Autrement dit, le procédé proposé est simultanément mis en œuvre pour détecter les décharges partielles dans l'isolant 2 du premier conducteur électrique 1, dans l'isolant 2' du deuxième conducteur électrique 1', et dans l'isolant 2" du troisième conducteur électrique 1".

Le même procédé de détection de décharge partielles peut être appliqué sur chacun des trois conducteurs électriques 1, 1', 1".

Le matériel nécessaire à la détection de décharges partielles forme un équipement 10 de détection de décharges partielles.

L'équipement 10 de détection de décharges partielles, comporte :

- un capteur 3 configuré pour fournir un signal électrique S représentatif d'une décharge partielle dans un isolant 2 d'un conducteur électrique 1,
- une unité électronique de contrôle 5 configurée pour mettre en œuvre le procédé de détection de décharges partielles tel que décrit précédemment.

Pour pouvoir assurer une détection simultanée sur les conducteurs électriques respectivement associés aux trois phases, l'équipement 10 de détection de décharges partielles comporte :

- trois capteurs 3,3',3", chaque capteur 3,3',3" étant configuré pour fournir un signal électrique S,S',S" représentatif d'une décharge partielle dans un isolant 2,2',2" d'un conducteur électrique 1,
- une unité électronique de contrôle 5 configurée pour mettre en œuvre le procédé de détection de décharges partielles tel que décrit précédemment.

L'unité électronique de contrôle 5 comprend trois canaux d'acquisition de données, chaque canal d'acquisition traitant respectivement le signal d'un capteur 3,3',3".

**Revendications**

1. Procédé de détection de décharges partielles dans un isolant (2) d'un conducteur électrique (1) d'un appareil électrique (20) de moyenne tension ou de haute tension, le conducteur électrique (1) étant soumis à une tension alternative, le procédé comportant les étapes :

    (i) acquérir successivement un ensemble (E) d'échantillons d'un signal électrique (S) représentatif d'une décharge partielle dans l'isolant (2) du conducteur électrique (1),
    (ii) pour chaque échantillon de l'ensemble (E) d'échantillons, déterminer la valeur de la phase (P) de la tension alternative,
    (iii) établir une matrice bidimensionnelle (M) d'éléments ($M_{i,j}$), dans laquelle :

        - une première dimension de la matrice bidimensionnelle (M) correspond à un ensemble de plages de valeurs de phase (P) de la tension alternative,
        - une deuxième dimension de la matrice bidimensionnelle (M) correspond à un ensemble de plages d'amplitudes des échantillons de l'ensemble (E) d'échantillons du signal électrique (S), et
        - la valeur de chaque élément ($M_{i,j}$) de la matrice bidimensionnelle (M) est égale au nombre d'échantillons compris dans la plage de valeurs de phase (P) de la tension alternative associée audit élément de la matrice bidimensionnelle (M) et compris dans la plage d'amplitude du signal électrique (S) associée audit élément de la matrice bidimensionnelle (M),

    (iv) déterminer dans la matrice bidimensionnelle

(M) établie une portion (B) correspondant à un bruit électrique, dite zone bruitée (B), en fonction d'une condition basée sur au moins :

        -- une première grandeur statistique (G1) représentative d'un nombre de valeurs associées à une plage d'amplitude du signal électrique (S),
        -- une deuxième grandeur statistique (G2) représentative d'une variabilité du nombre de valeurs associées à ladite plage d'amplitude du signal électrique (S),

    (v) pour chaque élément ($M_{i,j}$) de la matrice bidimensionnelle (M) faisant partie de ladite zone bruitée (B), remplacer la valeur dudit élément ($M_{i,j}$) par le résultat d'une fonction mathématique d'au moins :

        - un premier élément de la matrice bidimensionnelle (M) situé hors de la zone bruitée (B), dit premier élément de référence (R1), le premier élément de référence (R1) étant associé à :

            -- la même plage de valeurs de phase (P) de la tension électrique que ledit élément ($M_{i,j}$), et associé à
            -- une plage d'amplitude inférieure à la plage d'amplitude dudit élément ($M_{i,j}$), et

        - un deuxième élément de la matrice bidimensionnelle (M) situé hors de la zone bruitée (B), dit deuxième élément de référence (R2), le deuxième élément de référence (R2) étant associé à :

            -- la même plage de valeurs de phase (P) de la tension électrique que ledit élément ($M_{i,j}$), et associé à
            -- une plage d'amplitude supérieure à la plage d'amplitude dudit élément ($M_{i,j}$),

    de façon à établir une matrice corrigée bidimensionnelle (M_Cor) d'éléments,
    (vi) détecter la présence de décharges partielles ou l'absence de décharges partielles dans l'isolant (2) à partir de la matrice corrigée (M_Cor) établie.

2. Procédé de détection de décharges partielles selon la revendication 1, dans lequel, pour chaque élément (Mi,j) de la matrice bidimensionnelle (M) faisant partie de ladite zone bruitée (B) :

        - le premier élément de référence (R1) est associé à la plage d'amplitude immédiatement inférieure à la plage d'amplitude dudit élément ($M_{i,j}$), et
- le deuxième élément de référence (R2) est associé à la plage d'amplitude immédiatement supérieure à la plage d'amplitude dudit élément ($M_{i,j}$).

3. Procédé de détection de décharges partielles selon la revendication 1 ou 2, dans lequel, pour chaque élément ($M_{i,j}$) de la matrice bidimensionnelle (M) faisant partie de ladite zone bruitée (B), la valeur dudit élément ($M_{i,j}$) est remplacée par le résultat d'une fonction mathématique d'au moins :

    - un groupe de premiers éléments de la matrice bidimensionnelle (M) situés hors de la zone bruitée (B), dit groupe (T1) de premiers éléments de référence, chaque élément du groupe (T1) de premiers éléments de référence étant respectivement associé à une plage d'amplitude inférieure à la plage d'amplitude dudit élément ($M_{i,j}$), et
    - un groupe de deuxièmes éléments de la matrice bidimensionnelle (M) situés hors de la zone bruitée (B), dit groupe (T2) de deuxième éléments de référence, chaque élément du groupe (T2) de deuxièmes éléments de référence étant respectivement associé à une plage d'amplitude supérieure à la plage d'amplitude dudit élément ($M_{i,j}$).

4. Procédé de détection de décharges partielles selon la revendication 3, dans lequel les plages d'amplitudes du groupe (T1) de premiers éléments de référence sont des plages consécutives, et
les plages d'amplitudes du groupe (T2) de deuxièmes éléments de référence sont des plages consécutives.

5. Procédé de détection de décharges partielles selon la revendication 3 ou 4, dans lequel, pour chaque élément ($M_{i,j}$) de la matrice bidimensionnelle (M) faisant partie de ladite zone bruitée (B),
chaque élément du groupe (T1) de premiers éléments de référence est respectivement associé à la même plage de valeurs de phase (P) de la tension électrique que ledit élément ($M_{i,j}$), et :
chaque élément du groupe (T2) de deuxièmes éléments de référence est respectivement associé à la même plage de valeurs de phase (P) de la tension électrique que ledit élément ($M_{i,j}$).

6. Procédé de détection de décharges partielles selon la revendication 3 ou 4, dans lequel, pour chaque élément ($M_{i,j}$) de la matrice bidimensionnelle (M) faisant partie de ladite zone bruitée (B),
au moins un élément du groupe (T1) de premiers éléments de référence est associé à une plage de valeurs de phase (P) différente de la plage de valeurs de phase dudit élément ($M_{i,j}$), et :
au moins un élément du groupe (T2) de deuxièmes éléments de référence est associé à une plage de valeurs de phase (P) différente de la plage de valeurs de phase dudit élément ($M_{i,j}$).

7. Procédé de détection de décharges partielles selon l'une des revendications précédentes, dans lequel la première grandeur statistique (G1) représentative d'un nombre de valeurs associées à une plage d'amplitude du signal électrique (S) est une valeur moyenne (Moy) des valeurs des éléments ($M_{i,j}$) de la matrice bidimensionnelle (M) associés à ladite plage d'amplitude du signal électrique (S),
la moyenne (Moy) étant déterminée sur un sous-ensemble des plages de valeurs de phase de la tension alternative.

8. Procédé de détection de décharges partielles selon l'une des revendications précédentes, dans lequel la deuxième grandeur statistique (G2) représentative d'une variabilité du nombre de valeurs associées à ladite plage d'amplitude du signal électrique (S) est un écart-type des valeurs des éléments ($M_{i,j}$) de la matrice bidimensionnelle (M) associés à ladite plage d'amplitude du signal électrique (S),
l'écart-type étant déterminé sur un sous-ensemble des plages de valeurs de phase de la tension alternative.

9. Procédé de détection de décharges partielles selon l'une des revendications 1 à 8, dans lequel, à l'étape (iv), un élément ($M_{i,j}$) de la matrice bidimensionnelle (M) fait partie de ladite zone bruitée (B) si :

    - la première grandeur statistique (G1), déterminée pour la plage d'amplitude dudit élément ($M_{i,j}$), est supérieure à un premier seuil, et
    - la deuxième grandeur statistique (G2), déterminée pour la plage d'amplitude dudit élément ($M_{i,j}$), est inférieure à un deuxième seuil.

10. Procédé de détection de décharges partielles selon l'une des revendications 1 à 8, dans lequel, à l'étape (iv), un élément ($M_{i,j}$) de la matrice bidimensionnelle (M) fait partie de ladite zone bruitée (B) si un ratio de :

    - la première grandeur statistique (G1), déterminée pour la plage d'amplitude dudit élément ($M_{i,j}$), et de
    - la valeur maximale entre :

        -- la deuxième grandeur statistique (G2), déterminée pour la plage d'amplitude dudit élément ($M_{i,j}$), et
        -- une constante prédéterminée (c),

est supérieure à un troisième seuil prédéterminé.

11. Procédé de détection de décharges partielles selon l'une des revendications précédentes, dans lequel, à l'étape (iv), la zone bruitée (B) de la matrice bidimensionnelle (M) comprend l'ensemble des plages de valeurs de phase de la tension.

12. Procédé de détection de décharges partielles selon l'une des revendications précédentes, dans lequel, à l'étape (v), la valeur de chaque élément ($M_{i,j}$) de la matrice bidimensionnelle (M) faisant partie de la zone bruitée (B) est remplacée par une moyenne pondérée de la valeur de l'élément ($M_{i,j-1}$) associé à :

   - la même plage ($P_i$) de valeurs de la phase de la tension alternative, et à
   - la plage d'amplitude ($A_{j-1}$) immédiatement inférieure à la plage d'amplitude ($A_j$) dudit élément ($M_{i,j}$),

   et de la valeur de l'élément ($M_{i,j+1}$) associé à :

   - la même plage ($P_i$) de valeurs de la phase de la tension alternative, et à
   - la plage d'amplitude ($A_{j+1}$) immédiatement supérieure à la plage d'amplitude ($A_j$) dudit élément ($M_{i,j}$).

13. Procédé de détection de décharges partielles selon l'une des revendications précédentes, dans lequel l'échelle des unités du signal électrique (S) représentatif d'une décharge partielle dans l'isolant (2) du conducteur électrique (1) est une échelle logarithmique.

14. Equipement (10) de détection de décharges partielles, comportant :

   - un capteur (3) configuré pour fournir un signal électrique (S) représentatif d'une décharge partielle dans un isolant (2) d'un conducteur électrique (1),
   - une unité électronique de contrôle (5) configurée pour mettre en œuvre le procédé de détection de décharges partielles selon l'une des revendications précédentes.

15. Appareil électrique (20) de moyenne tension ou de haute tension, l'appareil électrique (20) comportant :

   - trois conducteurs électriques (1,1',1") correspondant respectivement à trois phases (L1,L2,L3) d'un réseau électrique triphasé de moyenne tension ou de haute tension,
   - trois isolants (2,2',2"), chaque isolant (2,2',2") entourant respectivement un conducteur électrique (1,1',1"),
   - trois capteurs (3,3',3"), chaque capteur (3,3',3") étant respectivement configuré pour fournir un signal électrique (S,S',S") représentatif d'une décharge partielle dans l'isolant (2,2',2") d'un conducteur électrique (1,1',1"),
   - une unité électronique de contrôle (5) configurée pour mettre en œuvre, pour chaque isolant (2,2',2"), le procédé de détection de décharges partielles selon l'une des revendications 1 à 13.

FIG. 1

FIG. 2

FIG. 3

**FIG. 4**

(A)                              (B)

FIG. 5

EP 4 782 851 A1

(A)                                                              (B)

FIG. 6

EP 4 782 851 A1

FIG. 7

EP 4 782 851 A1

**FIG. 8**

FIG. 9

EP 4 782 851 A1

(I)

(II)

(III)

(IV)

(V)

(VI)

# FIG. 10

**EP 4 782 851 A1**

Europäisches
Patentamt

European
Patent Office

Office européen
des brevets

# RAPPORT DE RECHERCHE EUROPEENNE

Numéro de la demande

EP 25 30 5090

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | US 2023/129833 A1 (BOGUSLAWSKI BARTOSZ [FR] ET AL) 27 avril 2023 (2023-04-27) * alinéa [0023]; revendications 1,3 * ----- | 1-15 | INV. G01R31/12 |

**DOMAINES TECHNIQUES RECHERCHES (IPC)**

G01R

Le présent rapport a été établi pour toutes les revendications

| Lieu de la recherche | Date d'achèvement de la recherche | Examinateur |
|---|---|---|
| Munich | 10 juin 2025 | Dogueri, Ali Kerem |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

31

**EP 4 782 851 A1**

## ANNEXE AU RAPPORT DE RECHERCHE EUROPEENNE
## RELATIF A LA DEMANDE DE BREVET EUROPEEN NO.

EP 25 30 5090

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

10-06-2025

| Document brevet cité au rapport de recherche | Date de publication | Membre(s) de la famille de brevet(s) | Date de publication |
|---|---|---|---|
| US 2023129833 A1 | 27-04-2023 | CN 116027150 A | 28-04-2023 |
| | | EP 4170362 A1 | 26-04-2023 |
| | | FR 3128539 A1 | 28-04-2023 |
| | | US 2023129833 A1 | 27-04-2023 |

EPO FORM P0460

Pour tout renseignement concernant cette annexe : voir Journal Officiel de l'Office européen des brevets, No.12/82

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- The effects of superimposed impulse transients on partial discharge in XLPE cable joint. *Electrical Power and Energy Systems*, 2019, vol. 110, 497-509

- **EDWARD GULSKI**. *Computer aided recognition of partial dicharges using statistical tools*